(19) Europäisches Patentamt
European Patent Office
Office européen des brevets

(11) **EP 4 253 311 B1**

(12) **EUROPEAN PATENT SPECIFICATION**

(45) Date of publication and mention
of the grant of the patent:
**11.02.2026 Bulletin 2026/07**

(51) International Patent Classification (IPC):
**B67D 1/08** *(2006.01)*    **F25B 21/02** *(2006.01)*
**H10N 10/10** *(2023.01)*

(21) Application number: **21915559.5**

(52) Cooperative Patent Classification (CPC):
**F25B 21/02; B67D 1/0869; H10N 10/10;**
B67D 2210/00002; B67D 2210/00047;
F25B 2321/023

(22) Date of filing: **01.12.2021**

(86) International application number:
**PCT/KR2021/018038**

(87) International publication number:
**WO 2022/145761 (07.07.2022 Gazette 2022/27)**

(54) **COLD-WATER GENERATING APPARATUS AND WATER PURIFIER COMPRISING SAME**

VORRICHTUNG ZUR ERZEUGUNG VON KALTWASSER UND WASSERREINIGER DAMIT

APPAREIL DE GÉNÉRATION D'EAU FROIDE ET PURIFICATEUR D'EAU LE COMPRENANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.12.2020 KR 20200187670**

(43) Date of publication of application:
**04.10.2023 Bulletin 2023/40**

(73) Proprietor: **Coway Co., Ltd.**
**Gongju-si, Chungcheongnam-do 32508 (KR)**

(72) Inventors:
• **YONG, Min Chul**
**Gongju-si, Chungcheongnam-do 32508 (KR)**
• **KIM, Chung Rae**
**Gongju-si, Chungcheongnam-do 32508 (KR)**
• **KIM, Jeong Yeon**
**Gongju-si, Chungcheongnam-do 32508 (KR)**
• **CHOI, In Du**
**Gongju-si, Chungcheongnam-do 32508 (KR)**
• **PARK, Chan Jung**
**Gongju-si, Chungcheongnam-do 32508 (KR)**

(74) Representative: **BCKIP Part mbB**
**MK1**
**Landsbergerstraße 98, 3.Stock**
**80339 München (DE)**

(56) References cited:
WO-A1-2020/222487     DE-A1- 102012 012 447
JP-A- 2013 142 524      KR-A- 20130 140 921
KR-A- 20130 140 921     KR-A- 20140 098 017
KR-A- 20160 097 758     KR-A- 20180 029 467
KR-A- 20180 029 467     KR-A- 20180 040 954
KR-B1- 101 435 108      US-A1- 2018 105 410

**Description**

[Technical Field of the Invention]

The present invention relates to a cold-water generating apparatus and a water purifier comprising the same, in which: by arranging a block member to surround the outer circumferential surface of a flow path member through which fluid flows, and cooling the block member so that the fluid is cooled, thereby sufficiently lowering the temperature at which the fluid is cooled; and by arranging cooling passages respectively in a plurality of zones provided in the block member and thermally separated from one another, providing a connection pipe to allow the fluid to sequentially flow through the cooling passages, and preventing heat exchange from occurring between the fluid introduced through the connection pipe and the fluid discharged therefrom, the maximum amount of cold water can be secured, thereby improving user satisfaction.

[Background of the Invention]

In general, the apparatus for generating cold water is an apparatus for cooling water which is supplied from a faucet or bottled water and providing the same to a user. Such a cold-water generating apparatus is mainly installed for generating low-temperature drinking water, such as a water purifier, a carbonated water machine, a cold/hot water machine and the like, but it may be used in various fields requiring the generation of cold water.

European Patent Publication No. 3674630 of Coway Co., Ltd. discloses a conventional water purifier. The water purifier is provided with an internal space, a tank body having inlet and outlet ports formed therein, a thermoelectric module for cooling the water contained in the tank body, and a cold sink for transferring cold air from the thermoelectric module to the tank body. In this case, the cold sink is arranged on one side of the tank body and is configured to cool the water accommodated inside the tank body, and in this way, since cold water is generated without a separate compartment inside the tank body, there is a problem in that the cooling efficiency of the cold water is lowered because the relatively high-temperature water obtained and the cooled cold water continuously exchange heat.

The cold water-generating apparatus disclosed in Korean Patent Application Laid-Open No. 10-2013-0001910 of Coway Co., Ltd. discloses a flow path that is partitioned on a plane, a block member surrounding the planar flow path, and a thermoelectric module that is disposed on one side of the block member. According to this structure, there is an advantage in that cooling efficiency is improved because it is difficult to mix inflow water and cooled water due to the partitioned flow path. However, there is a problem in that it is difficult to maintain the cool air of cold water near the inlet because the amount of water accommodated by the planar partitioned flow path is limited and the area to be cooled by a single thermoelectric module is wide.

In the cold water-generating apparatuses disclosed in Korean Patent Application Laid-Open No. 10-1262719 of Young-man PARK and Korean Patent Application Laid-Open No. 10-2014-0098017 of Revotech Co., Ltd., disclosed is a plurality of thermoelectric modules in which a plurality of block members respectively including a flow path that are partitioned by a plane are stacked, and are coupled to each block member. According to this structure, since the plurality of flow paths are respectively cooled, there are advantages in that the amount of chilled water can be increased to some extent and cooling performance is improved. However, since the planar partition flow path is still used, the amount of cold water is limited, and in order to increase the amount of cold water, the width of the block member must be increased, thereby reducing cooling performance. Moreover, since a plurality of thermoelectric modules are required, the manufacturing cost is high, and since a plurality of bulky thermoelectric module heat dissipation means must be installed on both sides, it is very disadvantageous for the miniaturization of final products such as water purifiers.

In the cold water-generating apparatus disclosed in Korean Patent Application Laid-Open No. 10-2020-0106673 of Coway Co., Ltd., disclosed is a single thermoelectric module in which a plurality of flow paths having different outer diameters that are formed in a helical shape and arranged to overlap each other are disposed close to the outermost flow path. According to this structure, since three-dimensional helical-shaped flow paths are used and a plurality of flow paths are used, there is an advantage in that the amount of cold water can be increased. However, it is difficult for the cold air of the thermoelectric module to be transmitted to the innermost flow path, and since each flow path is in thermal contact with each other, heat supplied through the relatively high-temperature water obtained is transferred to the other flow path by conduction, and thus, there is a problem in that the cooling efficiency is reduced.

KR 2014 0098017 A discloses a direct cooling type module using a thermoelectric element for a water purifier, and specifically, a heat exchange effect is achieved by allowing the fluid supplied in a plurality of cooled cooling flow path blocks having a thermoelectric element to flow in a zigzag.

KR 2013 0140921 A discloses a cooling device for a water purifier. The cooling device allows a user to drink raw water directly discharged to outside through a cold water cock without separately storing the raw water in a water tank, wherein the raw water circulated in a circulation flow path is cooled by a thermoelectric element which is a cooling unit.

[Disclosure of the Invention]

[Technical Problem]

In order to solve the above problems, the apparatus for generating cold water according to the present invention is directed to improving user satisfaction by arranging a block member to surround the outer circumferential surface of the passage member through which a fluid flows, partitioning the inside of the block member, and cooling the block member such that the fluid is cooled, and the temperature at which the fluid is cooled can be sufficiently lowered through the blocked fluid passage, and furthermore, it is provided in the block member, but each cooling passage is disposed in a plurality of zones that are thermally separated from each other, and a connection pipe is provided such that the fluid sequentially flows through the cooling passage, and through this, by preventing heat exchange between the inflowing fluid and the outflowing fluid, the maximum amount of cold water is secured.

The apparatus for generating cold water according to an exemplary embodiment of the present invention is directed to improving manufacturability through structural simplification, because thermally mutually separated zones are formed in a plurality of unit blocks, and the plurality of unit blocks can be simply thermally separated from each other by forming a first separation space such that the plurality of unit blocks are spaced apart from each other.

The apparatus for generating cold water according to the present invention is directed to improving user satisfaction through reducing the manufacturing costs and miniaturization of an apparatus, because the thermoelectric module is arranged to overlap the first to n-th cooling passages, and thus, it is possible to cool a plurality of cooling passages by using a single thermoelectric module.

The apparatus for generating cold water according to an exemplary embodiment of the present invention is directed to improving user satisfaction, because while the cooling member is disposed on one side of the block member in a depth direction, the fluid introduced to the other side in the depth direction through the inlet is cooled while flowing along the cooling passage in a direction toward one side in the depth direction (direction closer to the cooling member), and it is continuously cooled while moving to the other cooling passage through a connection pipe that is disposed on one side in the depth direction, and the cooled fluid flows along a direction toward the other side in the depth direction (direction away from the cooling member) and is discharged through an outlet that is disposed on the other side in the depth direction, and thus, the maximum amount of cold water is secured by preventing heat exchange between the inflowing fluid and the outflowing fluid.

The apparatus for generating cold water according to an exemplary embodiment of the present invention is directed to improving user satisfaction, because while the cooling member is disposed on one side of the block member in a depth direction, the fluid introduced to the other side in the depth direction through the inlet is cooled while flowing along the cooling passage in a direction toward one side in the depth direction (direction closer to the cooling member), and it is continuously cooled while moving to the other cooling passage through a connection pipe that is disposed on one side in the depth direction, and since the cooled fluid flows along the cooling passage in a direction toward one side in the depth direction (direction closer to the cooling member) and is discharged through an outlet that is disposed on one side in the depth direction, and thus, the maximum amount of cold water is secured by preventing heat exchange between the inflowing fluid and the outflowing fluid.

The apparatus for generating cold water according to an exemplary embodiment of the present invention is directed to reducing the manufacturing cost and improving manufacturability through structural simplification, because a plurality of unit blocks are thermally interconnected by a connection rib, and thus, it is possible to simultaneously cool a plurality of unit blocks by using a cooling member.

The apparatus for generating cold water according to an exemplary embodiment of the present invention is directed to reducing the manufacturing cost and improving manufacturability through structural simplification, because a plurality of unit blocks are thermally interconnected by a connection rib, and thus, it is possible to simultaneously cool the plurality of unit blocks by using fewer cooling members than the unit blocks.

The apparatus for generating cold water according to an exemplary embodiment of the present invention is directed to improving user satisfaction, because the cooling passage is three-dimensionalized as it is wound while including a straight passage and a curved passage, and thus, the length of the entire passage through which the fluid flows through the block-shaped fluid passage increases such that not only a sufficient amount of cooled fluid can be secured, but also the miniaturization of an apparatus is possible because space efficiency is improved.

The apparatus for generating cold water according to an exemplary embodiment of the present invention is directed to improving user satisfaction through the light weight of an apparatus, because straight and curved blocks are provided to effectively cool the straight and curved passages, and a second separation space is formed to effectively prevent heat exchange between the cooled fluid and the inflowing fluid as the straight and curved blocks are spaced apart from each other, and thus, as the second separation space is formed, the weight of the block member is reduced.

The apparatus for generating cold water according to an exemplary embodiment of the present invention is directed to improving user satisfaction, because as the cooling passages are stacked and arranged in a helical shape and three-dimensionalized, the length of the entire passage is increased through the block-shaped fluid passage such that not only a sufficient amount of cooled fluid can be secured, but also the miniaturization of an apparatus is possible because space efficiency is improved.

The apparatus for generating cold water according to an exemplary embodiment of the present invention is directed to improving user satisfaction, because by forming the range of a width direction length of the block member to correspond to the size of the thermoelectric module, it is possible to secure sufficient cooling performance, and at the same time, the apparatus is miniaturized.

The apparatus for generating cold water according to an exemplary embodiment of the present invention is directed to improving user satisfaction, because by forming the range of a height direction length of the block member to correspond to the size of the thermoelectric module, it is possible to secure sufficient cooling performance, and at the same time, the apparatus is miniaturized.

The apparatus for generating cold water according to an exemplary embodiment of the present invention is directed to improving user satisfaction, because by forming the range of a depth direction length of the block member to correspond to the size of the thermoelectric module, it is possible to secure sufficient cooling performance, and at the same time, the apparatus is miniaturized.

The apparatus for generating cold water according to an exemplary embodiment of the present invention is directed to the deterioration of cooling performance of the block member by providing a case member that is made of an insulating material surrounding the outer circumferential surface of the block member.

The apparatus for generating cold water according to an exemplary embodiment of the present invention is directed to improving user satisfaction, because by placing a separate insulation wall between unit blocks, heat exchange between unit blocks is prevented more effectively, and the maximum amount of cold water is secured.

The water purifier according to the present invention is directed to improving user satisfaction, because the water purifier generates purified water by filtering raw water, and supplies the generated purified water to generate cold water, and the cold water generating unit arranges a block member to cover the outer circumferential surface of the passage member through which a fluid flows, and cools the block member to cool the fluid, and thus, it is possible not only to sufficiently lower the temperature at which the fluid is cooled, but also to respectively arrange cooling passages in a plurality of zones that are provided in the block member and are thermally separated from each other, and connecting pipes are provided such that the fluid flows sequentially through these cooling passages, and through this, the maximum amount of cold water is secured by preventing heat exchange between the inflowing fluid and the outflowing fluid.

[Technical Solution]

In order to achieve the above objects, the present invention provides an apparatus for generating cold water according to claim 1.

In the apparatus for generating cold water according to the present invention, the block member may include a plurality of unit blocks in which the zones are respectively formed and a first separation space in which each unit block is disposed to be spaced apart from each other by a predetermined distance.

In the apparatus for generating cold water according to the present invention, the thermoelectric module may be disposed on one side of the block member in a depth direction, wherein the inlet of the k-th cooling passage is disposed, with respect to the depth direction, far from the thermoelectric module, and the outlet of the k-th cooling passage is disposed, with respect to the depth direction, close to the thermoelectric module, and wherein the inlet of the k+1th cooling passage is disposed, with respect to the depth direction, close to the thermoelectric module, and the outlet of the k+1th cooling passage is disposed, with respect to the depth direction, far from the thermoelectric module.

In the apparatus for generating cold water according to the present invention, the thermoelectric module may be disposed on one side of the block member in a depth direction, wherein the inlet of the k-th cooling passage is disposed, with respect to the depth direction, far from the thermoelectric module, and the outlet of the k-th cooling passage is disposed, with respect to the depth direction, close to the thermoelectric module, and wherein the inlet of the k+1th cooling passage is disposed, with respect to the depth direction, far from the thermoelectric module, and the outlet of the k+1th cooling passage is disposed, with respect to the depth direction, close to the thermoelectric module.

In the apparatus for generating cold water according to the present invention, the first separation space may be disposed far from the thermoelectric module.

In the apparatus for generating cold water according to the present invention, the block member may include a connection rib that thermally interconnects one side of the unit block in a depth direction such that the cooling member simultaneously cools the plurality of unit blocks.

In the apparatus for generating cold water according to the present invention, the cooling member may include at least one thermoelectric module, and wherein the number of thermoelectric modules is less than the number of unit blocks.

In the apparatus for generating cold water according to the present invention, the cooling passage may include a straight passage through which the fluid flows in a straight direction and a curved passage through which the fluid flows in a curved direction, and the cooling passage is wound at least once such that the fluid sequentially flows through the straight passage and the curved passage.

In the apparatus for generating cold water according to the present invention, the block member may include a straight block surrounding the outer circumferential surface of the straight passage, a curved block surrounding the outer circumferential surface of the curved passage, and a second separation space that spaces apart the straight block and the curved block that are disposed to face each other.

In the apparatus for generating cold water according to the present invention, the cooling passages may be stacked in a helical shape.

In the apparatus for generating cold water according to the present invention, the thermoelectric module may be provided with a rectangular periphery having a width direction length (A) and a height direction length (B), and wherein when the thermoelectric length (C) of the thermoelectric module is defined by the mathematical formula of C=√(AB), the width direction length (AA) of the block member satisfies the range of 1.5C < AA < 4C.

In the apparatus for generating cold water according to the present invention, the thermoelectric module may be provided with a rectangular periphery having a width direction length (A) and a height direction length (B), and wherein when the thermoelectric length (C) of the thermoelectric module is defined by the mathematical formula of C=√(AB), the height direction length (BB) of the block member satisfies the range of 2.3C < BB < 5.5C.

In the apparatus for generating cold water according to the present invention, the thermoelectric module may be provided with a rectangular periphery having a width direction length (A) and a height direction length (B), and wherein when the thermoelectric length (C) of the thermoelectric module is defined by the mathematical formula of C=√(AB), the depth direction length (DD) of the block member satisfies the range of C < DD < 3.7C.

The apparatus for generating cold water according to the present invention may further include a case member which is made of an insulating material surrounding the outer circumferential surface of the block member.

In the apparatus for generating cold water according to the present invention, the case member may include a heat insulating wall that is inserted and disposed into the first separation space.

In order to achieve the above objects, the present invention further provides a water purifier according to claim 16.

[Advantageous Effects]

According to the above configurations, the apparatus for generating cold water according to the present invention provides the effect of improving user satisfaction by arranging a block member to surround the outer circumferential surface of the passage member through which a fluid flows, partitioning the inside of the block member, and cooling the block member such that the fluid is cooled, and the temperature at which the fluid is cooled can be sufficiently lowered through the blocked fluid passage, and furthermore, it is provided in the block member, but each cooling passage is disposed in a plurality of zones that are thermally separated from each other, and a connection pipe is provided such that the fluid sequentially flows through the cooling passage, and through this, by preventing heat exchange between the inflowing fluid and the outflowing fluid, the maximum amount of cold water is secured.

The apparatus for generating cold water according to an exemplary embodiment of the present invention provides the effect of improving manufacturability through structural simplification, because thermally mutually separated zones are formed in a plurality of unit blocks, and the plurality of unit blocks can be simply thermally separated from each other by forming a first separation space such that the plurality of unit blocks are spaced apart from each other.

The apparatus for generating cold water according to the present invention provides the effect of improving user satisfaction through reducing the manufacturing costs and miniaturization of an apparatus, because the thermoelectric module is arranged to overlap the first to n-th cooling passages, and thus, it is possible to cool a plurality of cooling passages by using a single thermoelectric module.

The apparatus for generating cold water according to an exemplary embodiment of the present invention provides the effect of improving user satisfaction, because while the cooling member is disposed on one side of the block member in a depth direction, the fluid introduced to the other side in the depth direction through the inlet is cooled while flowing along the cooling passage in a direction toward one side in the depth direction (direction closer to the cooling member), and it is continuously cooled while moving to the other cooling passage through a connection pipe that is disposed on one side in the depth direction, and the cooled fluid flows along a direction toward the other side in the depth direction (direction away from the cooling member) and is discharged through an outlet that is disposed on the other side in the depth direction, and thus, the maximum amount of cold water is secured by preventing heat exchange between the inflowing fluid and the outflowing fluid.

The apparatus for generating cold water according to an exemplary embodiment of the present invention provides the effect of improving user satisfaction, because while the cooling member is disposed on one side of the block member in a depth direction, the fluid introduced to the other side in the depth direction through the inlet is cooled while flowing along the cooling passage in a direction toward one side in the depth direction (direction closer to the cooling member), and it is continuously cooled while moving to the other cooling passage through a connection pipe that is disposed on one side in the depth direction, and since the cooled fluid flows along the cooling passage in a direction toward one side in the depth direction (direction closer to the cooling member) and is discharged through an outlet that is disposed on one side in the depth direction, and thus, the maximum amount of cold water is secured by preventing heat exchange between the inflowing fluid and the outflowing fluid.

The apparatus for generating cold water according to an exemplary embodiment of the present invention provides the effects of reducing the manufacturing cost and improving manufacturability through structural simplification, because a plurality of unit blocks are thermally interconnected by a connection rib, and thus, it is possible to simultaneously cool a plurality of unit blocks by using a cooling member.

The apparatus for generating cold water according to an exemplary embodiment of the present invention provides the effects of reducing the manufacturing cost and improving manufacturability through structural simplification, because a plurality of unit blocks are thermally interconnected by a connection rib, and thus, it is possible to simultaneously cool the plurality of unit blocks by using fewer cooling members than the unit blocks.

The apparatus for generating cold water according to an exemplary embodiment of the present invention provides the effect of improving user satisfaction, because the cooling passage is three-dimensionalized as it is wound while including a straight passage and a curved passage, and thus, the length of the entire passage through which the fluid flows through the block-shaped fluid passage increases such that not only a sufficient amount of cooled fluid can be secured, but also the miniaturization of an apparatus is possible because space efficiency is improved.

The apparatus for generating cold water according to an exemplary embodiment of the present invention provides the effect of improving user satisfaction through the light weight of an apparatus, because straight and curved blocks are provided to effectively cool the straight and curved passages, and a second separation space is formed to effectively prevent heat exchange between the cooled fluid and the inflowing fluid as the straight and curved blocks are spaced apart from each other, and thus, as the second separation space is formed, the weight of the block member is reduced.

The apparatus for generating cold water according to an exemplary embodiment of the present invention provides the effect of improving user satisfaction, because as the cooling passages are stacked and arranged in a helical shape and three-dimensionalized, the length of the entire passage is increased through the block-shaped fluid passage such that not only a sufficient amount of cooled fluid can be secured, but also the miniaturization of an apparatus is possible because space efficiency is improved.

The apparatus for generating cold water according to an exemplary embodiment of the present invention provides the effect of improving user satisfaction, because by forming the range of a width direction length of the block member to correspond to the size of the thermoelectric module, it is possible to secure sufficient cooling performance, and at the same time, the apparatus is miniaturized.

The apparatus for generating cold water according to an exemplary embodiment of the present invention provides the effect of improving user satisfaction, because by forming the range of a height direction length of the block member to correspond to the size of the thermoelectric module, it is possible to secure sufficient cooling performance, and at the same time, the apparatus is miniaturized.

The apparatus for generating cold water according to an exemplary embodiment of the present invention provides the effect of improving user satisfaction, because by forming the range of a depth direction length of the block member to correspond to the size of the thermoelectric module, it is possible to secure sufficient cooling performance, and at the same time, the apparatus is miniaturized.

The apparatus for generating cold water according to an exemplary embodiment of the present invention provides the effect of the deterioration of cooing performance of the block member by providing a case member that is made of an insulating material surrounding the outer circumferential surface of the block member.

The apparatus for generating cold water according to an exemplary embodiment of the present invention provides the effect of improving user satisfaction, because by placing a separate insulation wall between unit blocks, heat exchange between unit blocks is prevented more effectively, and the maximum amount of cold water is secured.

The water purifier according to the present invention provides the effect of improving user satisfaction, because the water purifier generates purified water by filtering raw water, and supplies the generated purified water to generate cold water, and the cold water generating unit arranges a block member to cover the outer circumferential surface of the passage member through which a fluid flows, and cools the block member to cool the fluid, and thus, it is possible not only to sufficiently lower the temperature at which the fluid is cooled, but also to respectively arrange cooling passages in a plurality of zones that are provided in the block member and are thermally separated from each other, and connecting pipes are provided such that the fluid flows sequentially through these cooling passages, and through this, the maximum amount of cold water is secured by preventing heat exchange between the inflowing fluid and the outflowing fluid.

[Description of Drawings]

FIGS. 1 and 2 are perspective views illustrating the cold-water generating apparatus according to an exemplary embodiment of the present invention as viewed from different directions.

FIG. 3 is an exploded perspective view of the cold-water generating apparatus according to an exemplary embodiment of the present invention.

FIG. 4 is a perspective view showing a block member according to an exemplary embodiment of the present invention.

FIG. 5 is a perspective view illustrating a flow path member according to an exemplary embodiment of the present invention.

FIG. 6 is a front view showing a flow path member according to an exemplary embodiment of the present invention.

FIG. 7 is a plan view showing a block member according to an exemplary embodiment of the present invention.

FIG. 8 is a bottom view showing an upper case according to an exemplary embodiment of the present invention.

FIG. 9 is a plan view showing a lower case according to an exemplary embodiment of the present invention.

FIG. 10 is a perspective view illustrating a flow path member and a connecting pipe according to an exemplary embodiment of the present invention.

FIG. 11 is a perspective view illustrating a flow path member and a connecting pipe according to another exemplary embodiment of the present invention.

FIG. 12 is a perspective view showing a block member according to another exemplary embodiment of the present invention.

FIG. 13 is a front view showing a flow path member according to another exemplary embodiment of the present invention.

FIG. 14 is a perspective view showing a block member according to another exemplary embodiment of the present invention.

FIG. 15 is a front view showing a flow path member according to another exemplary embodiment of the present invention.

FIG. 16 is a perspective view showing a block member according to another exemplary embodiment of the present invention.

FIG. 17 is a cross-sectional view showing a flow path member according to another exemplary embodiment of the present invention.

FIG. 18 is a perspective view illustrating the width direction length, depth direction length and height direction length of a block member according to an exemplary embodiment of the present invention.

FIG. 19 is a graph showing changes in cooling time and cooling performance (number of cups) according to the width direction length of the block member according to an exemplary embodiment of the present invention.

FIG. 20 is a graph showing changes in cooling time and cooling performance (number of cups) according to the height direction length of a block member according to an exemplary embodiment of the present invention.

FIG. 21 is a graph illustrating changes in cooling time and cooling performance (number of cups) according to the depth direction length of a block member according to an exemplary embodiment of the present invention.

FIG. 22 is a block diagram of a water purifier according to an exemplary embodiment of the present invention.

[Detailed Description of the Exemplary Embodiments of the Invention]

The exemplary embodiments described in the present specification and the configurations shown in the drawings correspond to preferred exemplary embodiments of the present invention.

It is understood that the terms "include" or "have", when used in the present specification, are intended to describe the presence of stated features, integers, steps, operations, elements, components and/or a combination thereof but not preclude the possibility of the presence or addition of one or more other features, integers, steps, operations, elements, components or a combination thereof.

The presence of an element in/on "front", "rear", "upper or above or top" or "lower or below or bottom" of another element includes not only being disposed in/on "front", "rear", "upper or above or top" or "lower or below or bottom" directly in contact with other elements, but also cases in which another element being disposed in the middle, unless otherwise specified. In addition, unless otherwise specified, that an element is "connected" to another element includes not only direct connection to each other but also indirect connection to each other.

Hereinafter, the apparatus for generating cold water according to the present invention will be described with reference to the drawings.

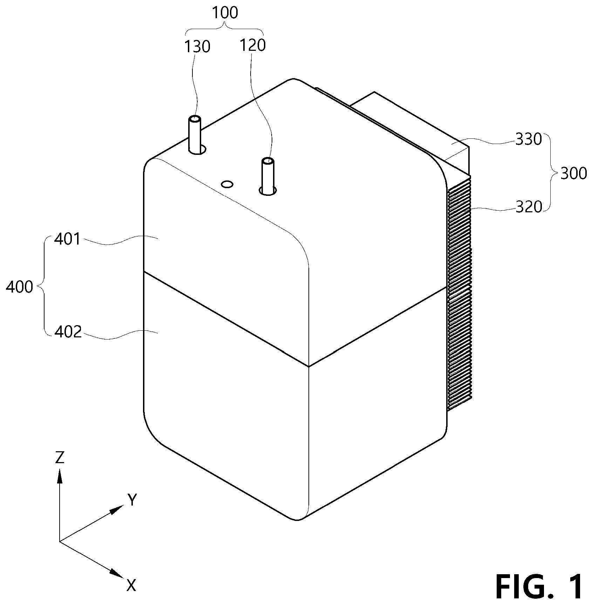

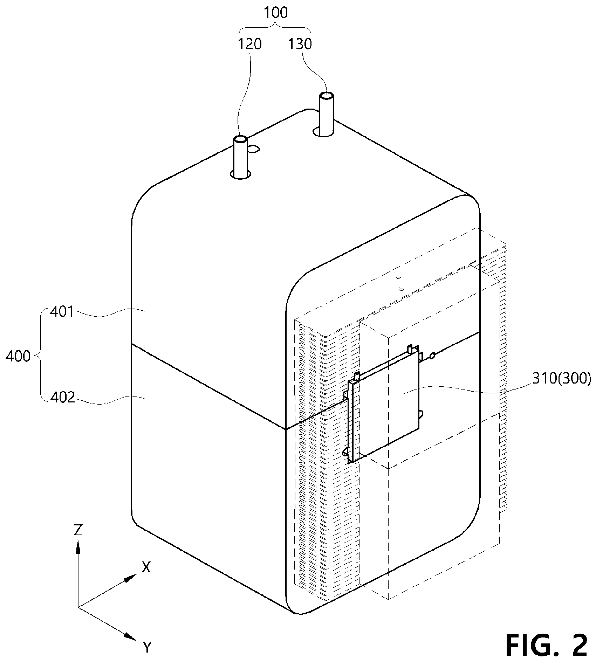

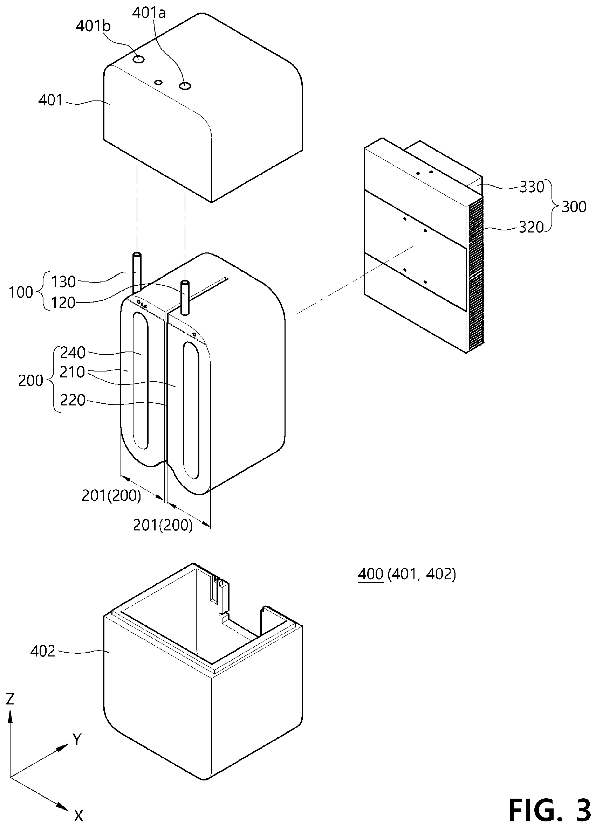

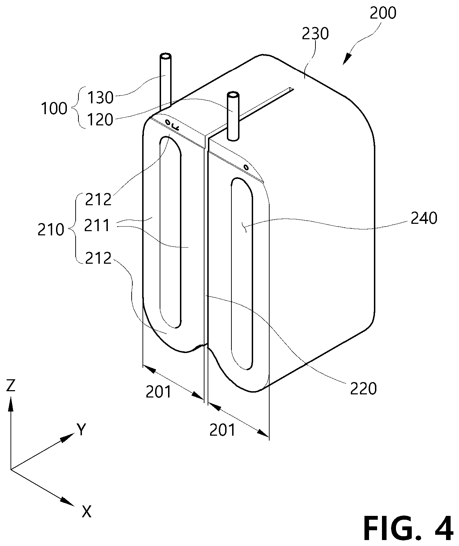

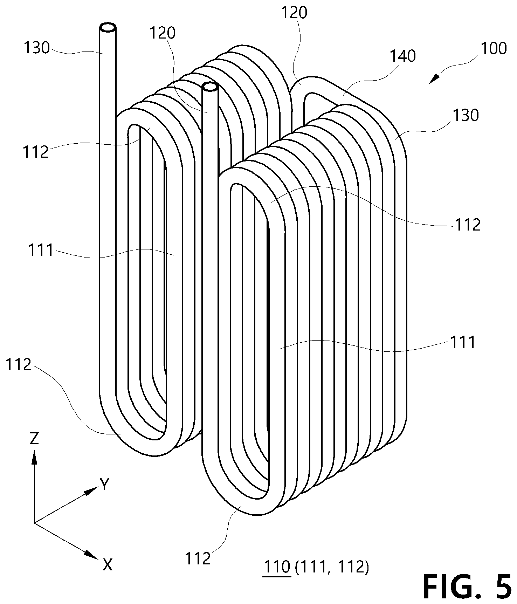

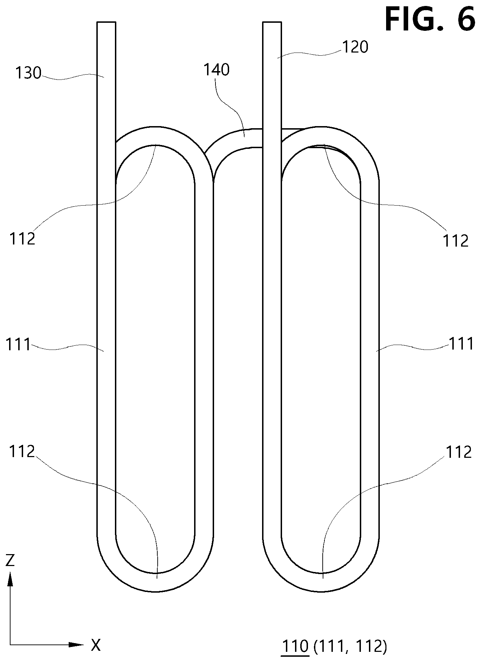

FIGS. 1 and 2 are perspective views illustrating the cold-water generating apparatus according to an exemplary embodiment of the present invention as viewed from different directions, FIG. 3 is an exploded perspective view of the cold-water generating apparatus according to an exemplary embodiment of the present invention, FIG. 4 is a perspective view showing a block member according to an exemplary embodiment of the present invention, FIG. 5 is a perspective view illustrating a flow path member according to an exemplary embodiment of the present invention, and FIG. 6 is a front view showing a flow path member according to an exemplary embodiment of the present invention. Herein, the X direction is the width direction of the cold water generating device, the Y direction is the depth direction of the cold water generating device, and the Z direction means the height direction of the cold water generating device. In order to clearly describe the present invention, parts that are not related to the description are omitted from the drawings.

As illustrated in FIGS. 1 to 3, the apparatus for generating cold water according to an exemplary embodiment of the present invention includes a flow path member 100 through which a fluid flows, a block member 200 which surrounds the outer circumferential surface of the flow path member 100 to thermally contact the flow path member 100, and a cooling member 300 which is provided with a thermoelectric module 310 that is disposed on one side of the block member 200 to cool the block member 200. The flow path member 100 provides a space through which a fluid flows. For example, if the flow path member 100 is formed in a tube shape having a circular cross-section with a certain diameter, a direct first-in-first-out structure in which the first introduced fluid flows out first as the fluid flows continuously is possible. The flow path member 100 is not only formed in a circular cross-section, but may be formed in a different cross-sectional shape if the space through which a fluid can flow is formed. The block member 200 is in thermal contact with the flow path member 100, but the block member 200 is disposed to surround the outer circumferential surface of the flow path member 100 to improve cooling performance to partition the inside of the block member 200. As described above, the block member 200 is disposed to surround the outer circumferential surface of the flow path member 100, but the die casting method may be used to manufacture the block member 200 in order to minimize the contact resistance between the block member 200 and the flow path member 100. That is, when the block member 200 is manufactured while the flow path member 100 is disposed in the die casting mold, the contact resistance between the block member 200 and the flow path member 100 is minimized, thereby improving the cooling performance of the fluid. The cooling member 300 includes a thermoelectric module 310 which is disposed on one side of the block member 200 to cool the block member 200. The thermoelectric module 310 is a device that performs cooling or heat generation by using the Peltier Effect, in which heat generation or heat absorption occurs at the connection point of the conducting wires that are made of different materials when a potential value is formed in a closed circuit. As an example, the thermoelectric module 310 manufactured in the form of a thin film may be applied, and when an electrical signal is input, it is configured such that one side absorbs heat, and the other side generates heat. Referring to FIG. 2, one side (thermal contact with the block member) of the thermoelectric module 310 may be a side where heat is absorbed and the temperature falls, and the other side of the thermoelectric module 310 may be a side where heat is generated and the temperature rises. The aforementioned block member 200 is cooled by an endothermic action occurring at one side of the thermoelectric module 310 to cool the flow path member 100. A heat dissipation fin 320 and a heat dissipation fan 330 for dissipating heat may be mounted on the other side of the thermoelectric module 310. This is to perform heat dissipation for the heat dissipation action on the other side when an endothermic action occurs on one side of the thermoelectric module 310. A plurality of these heat dissipation fins 320 may be provided to protrude from the opposite side surface to which the thermoelectric module 310 is coupled, and in this way, when the heat radiation fan 330 operates in a state where the heat radiation fin 320 is provided, the contact area with the outside air is increased, and thus, the heat dissipation effect through convective heat transfer can be increased. As described above, when the block member 200 is cooled by using the thermoelectric module 310, it is possible to minimize noise or vibration generation, and the weight and size of the cooling member 300 may be reduced.

As illustrated in FIG. 4, the block member 200 includes a plurality of zones 201 that are thermally separated from each other. When the plurality of zones 201 that are thermally separated from each other in this way are formed, heat exchange between the inflowing fluid and the outflowing fluid does not occur, thereby preventing the deterioration of cooling performance. In this case, as illustrated in FIGS. 5 and 6, the flow path member 100 includes first to n-th cooling passages 110 (where n is an integer of 2 or more) that are respectively disposed in the plurality of zones 201, an inlet 120 which is formed at one end of each of the cooling passages 110 of the block member 200 and exposed to the outside, an outlet 130 which is formed at the other end of each of the cooling passages 110 and exposed to the outside of the block member 200, and a connection pipe 140 for connecting the outlet 130 of the k-th cooling passage 110 (where k is 1 or more and less than or equal to n-1) and the inlet 120 of the k+1th cooling passage 110. That is, the cooling passage 110 is disposed in each thermally separated zone 201, and the inlet 120 is exposed to the outside of the block member 200 such that the fluid flows into the cooling passage 110, and as the outlet 130 is exposed to the outside of the block member 200 such that the fluid flows out of the cooling passage 110, the fluid flow inside the cooling passage 110 is possible. In this case, the connection pipe 140 is provided to connect the cooling passages 110 that are thermally separated from each other. For example, as illustrated in FIG. 4, when two zones 201 that are thermally separated from each other are provided, as illustrated in FIG. 5, each zone 201 is provided with one cooling passage 110, respectively, such that a total of two cooling passages 110 are provided. In addition, when the cooling passage 110 provided with the inlet 120 is defined as the first cooling passage 110 and the cooling passage 110 provided with the outlet 130 is defined as the second cooling passage 110, an inlet 120 through which a fluid flows into the first cooling passage 110 and an outlet 130 through which a fluid flows out of the first cooling passage 110 may be formed, and an inlet 120 through which a fluid flows into the second cooling passage 110 and an outlet through which a fluid flows out of the second cooling passage 110 may be formed. The inlet 120 and outlet 130 refer to parts through which the fluid flows in or out, and they refer to not only the inlet 120 and the outlet 130 in the form of a hole that is respectively formed at both ends of the cooling passage 110 that is integrally formed, but also collectively refer to all parts of the pipe-shaped flow path through which a fluid flows in or out. Moreover, since the outlet 130 of the first cooling passage 110 and the inlet 120 of the second cooling passage 110 may communicate with each other by the connection pipe 140, the fluid that is cooled while flowing through the first cooling passage 110 moves to the second cooling passage 110 through the connection pipe 140 and is continuously cooled while flowing through the second cooling passage 110. That is, as described above, the block member 200 is disposed to surround the outer circumferential surface of the flow path member 100 through which the fluid flows to partition the inside of the block member 200, and the block member 200 is cooled to allow the fluid to flow such that the temperature at which the fluid is cooled through the block-shaped fluid flow path can be sufficiently lowered, and the cooling passages 110 are disposed in each of the plurality of zones 201 that are provided in the block member 200 and are thermally separated from each other, and a connection pipe 140 is provided such that the fluid sequentially flows through these cooling passages 110, and through this, it is possible to improve user satisfaction by securing the maximum amount of cold water by preventing heat exchange between the inflowing fluid and the outflowing fluid.

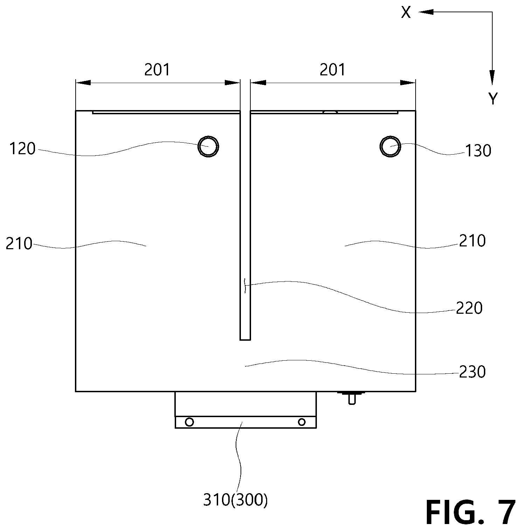

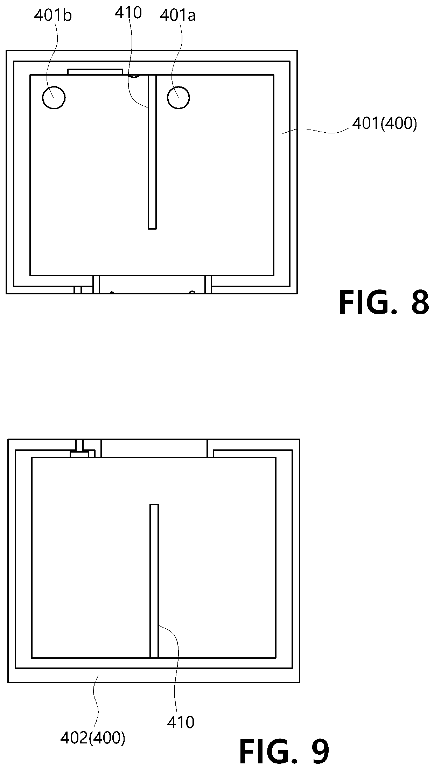

FIG. 7 is a plan view showing a block member according to an exemplary embodiment of the present invention, FIG. 8 is a bottom view showing an upper case according to an exemplary embodiment of the present invention, and FIG. 9 is a plan view showing a lower case according to an exemplary embodiment of the present invention.

As illustrated in FIG. 7, in the apparatus for generating cold water according to an exemplary embodiment of the present invention, the block member 200 may include a plurality of unit blocks 210 in which the zones 201 are respectively formed, and a first separation space 220 for disposing each of the unit blocks 210 to be spaced apart from each other by a predetermined distance. As described above, the block member 200 may be manufactured by the die casting method, and a diaphragm structure for forming the first separation space 220 may be provided in the die casting mold. Alternatively, after the block member 200 is manufactured in a state where the first separation space 220 is not formed, it is also possible to partially cut the block member 200 such that the first separation space 220 is formed. In this way, thermally separated zones 201 are respectively formed in the plurality of unit blocks 210, and by forming the first separation space 220 such that the plurality of unit blocks 210 are spaced apart from each other, the plurality of unit blocks 210 may be simply thermally separated from each other, and it is possible to improve manufacturability through structural simplification. In this case, as illustrated in FIG. 3, a case member 400 made of an insulating material surrounding the outer circumferential surface of the block member 200 may be provided, and the case member 400 may include an upper case 401 for surrounding the upper part of the block member 200 as illustrated in FIG. 8, and a lower case 402 for surrounding the lower part of the block member 200 as illustrated in FIG. 9. An inlet hole 401a through which the inlet 120 is disposed to penetrate and an outlet hole 401b through which the outlet 130 is disposed to penetrate may be formed in the upper case 401.

In the apparatus for generating cold water according to an exemplary embodiment of the present invention, in the cooling member 300, the thermoelectric module 310 is disposed to overlap the first to n-th cooling passages 110. Such overlap means that the cooling passages 110 are arranged such that the projection surface of the cooling passages 110 that is formed toward the surface on which the cooling member 300 is disposed overlaps the thermoelectric module 310. In this way, when the thermoelectric module 310 is disposed to overlap the first to n-th cooling passages, a single thermoelectric module 310 or a smaller number of thermoelectric modules 310 than the number of cooling passages 110 are used to cool the plurality of cooling passages 110, and thus, it is possible to reduce the manufacturing cost and improve user satisfaction through the miniaturization of an apparatus.

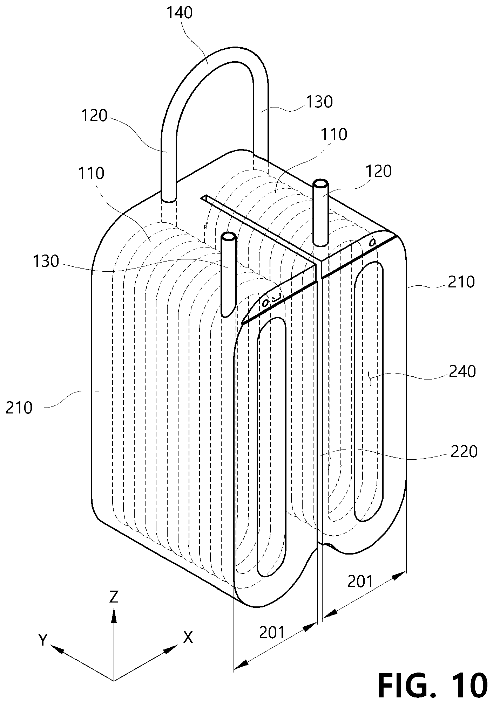

FIG. 10 is a perspective view illustrating a flow path member and a connecting pipe according to an exemplary embodiment of the present invention.

As illustrated in FIG. 10, in the apparatus for generating cold water according to an exemplary embodiment of the present invention, the thermoelectric module 310 may be disposed on one side of the block member 200 in the depth direction Y, the inlet 120 of the k-th cooling passage 110 may be disposed far from the thermoelectric module 310, the inlet 120 of the k+1th cooling passage 110 may be disposed close to the thermoelectric module 310, and the outlet 130 of the k+1th cooling passage 110 may be disposed far from the thermoelectric module 310. For example, when it is assumed that the block member 200 is provided with two cooling passages 110 in a state where the cooling member 300 is disposed on one side of the block member 200 in the depth direction Y, since the inlet 120 of the first cooling passage 110 is disposed far from the thermoelectric module 310 and the outlet 130 of the first cooling passage 110 is disposed close to the thermoelectric module 310, the fluid flowing through the first cooling passage 110 is cooled while moving in a direction closer to the thermoelectric module 310. In this way, the cooled fluid moves to the second cooling passage 110, but since the inlet 120 of the second cooling passage 110 is disposed close to the thermoelectric module 310 and the outlet of the second cooling passage 110 is disposed far from the thermoelectric module, the fluid flowing through the second cooling passage 110 is continuously cooled while moving in a direction away from the thermoelectric module 310. That is, the fluid introduced to the other side in the depth direction Y through the inlet 120 is cooled while flowing along the cooling passage 110 in a direction (direction closer to the cooling member 300) toward one side in the depth direction Y, and it is continuously cooled while moving to the other cooling passage 110 through the connection pipe 140 that is disposed on one side in the depth direction Y, and since the cooled fluid flows along the cooling passage 110 in a direction toward the other side in the depth direction Y (direction away from the cooling member) and is discharged through the outlet 130 that is disposed on the other side in the depth direction Y, heat exchange between the inflowing fluid and the outflowing fluid does not occur such that it is possible to secure the maximum amount of cold water, and through this, it is possible to improve user satisfaction. In addition, since the outlet 130 of the first cooling channel 110 and the inlet 120 of the second cooling channel 110 are both provided at positions close to the thermoelectric module 310, the length of the connecting pipe 140 connecting the same is formed to be short such that the flow path member 100 may be miniaturized as a whole.

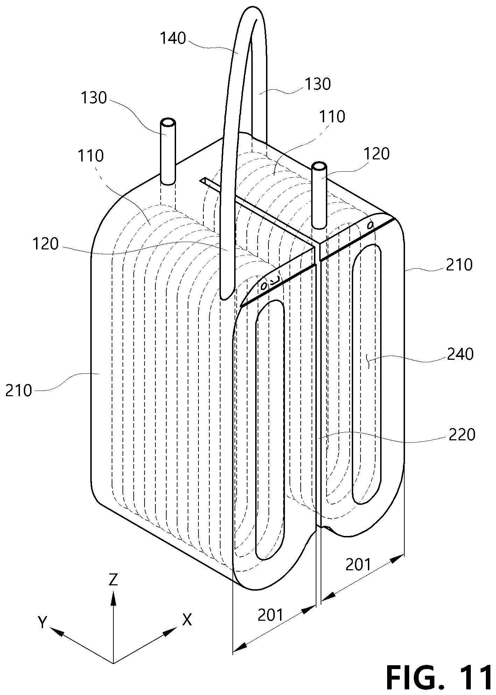

FIG. 11 is a perspective view illustrating a flow path member and a connecting pipe according to another exemplary embodiment of the present invention.

As illustrated in FIG. 11, in the apparatus for generating cold water according to another exemplary embodiment of the present invention, the thermoelectric module 310 may be disposed on one side of the block member 200 in the depth direction Y, the inlet 120 of the k-th cooling passage 110 may be disposed far from the thermoelectric module 310, the outlet 130 of the k-th cooling passage 110 may be disposed close to the thermoelectric module 310, the inlet 120 of the k+1th cooling passage 110 may be disposed far from the thermoelectric module 310, and the outlet 130 of the k+1th cooling passage 110 may be disposed close to the thermoelectric module 310. For example, when the block member 200 is provided with two cooling passages 110 while the cooling member 300 is disposed on one side of the block member 200 in the depth direction Y, since the inlet 120 of the first cooling passage 110 is disposed far from the thermoelectric module 310 and the outlet 130 of the first cooling passage 110 is disposed close to the thermoelectric module 310, the fluid flowing through the first cooling passage 110 is cooled while moving in a direction closer to the thermoelectric module 310. In this way, the cooled fluid moves to the second cooling passage 110, the inlet 120 of the second cooling passage 110 is disposed far from the thermoelectric module 310, and the outlet 130 of the second cooling passage 110 is disposed close to the thermoelectric module 310, and thus, the fluid flowing through the second cooling passage 110 is also continuously cooled while moving in a direction closer to the thermoelectric module 310. That is, while the cooling member 300 is disposed on one side in the depth direction Y of the block member 200, the fluid introduced to the other side in the depth direction Y through the inlet 120 is cooled while flowing along the cooling passage 110 in a direction toward one side in the depth direction Y (direction closer to the cooling member), and it is continuously cooled while moving to the other cooling passage 110 through the connection pipe 140 that is disposed on one side in the depth direction Y, and since the cooled fluid is discharged through the outlet 130 that is disposed on one side in the depth direction Y while flowing along the cooling passage 110 in a direction toward one side in the depth direction Y (direction closer to the cooling member), heat exchange between the inflowing fluid and the outflowing fluid does not occur such that it is possible to secure the maximum amount of cold water, and through this, it is possible to improve user satisfaction. In addition, since the fluid is cooled through the thermoelectric module 310 even in the process of flowing out through the outlet 130 of the second cooling passage 110, it is possible to further improve the cooling performance of fluid.

As illustrated in FIG. 7, in the apparatus for generating cold water according to an exemplary embodiment of the present invention, the first separation space 220 may be disposed far from the thermoelectric module 310. That is, while the thermoelectric module 310 is disposed on one side in the depth direction Y, when the inlet 120 of the first cooling passage 110 and the outlet 130 of the second cooling passage 110 that is disposed adjacent thereto are disposed on the other side in the depth direction Y, respectively, and at the same time, when the first separation space 220 is also disposed on the other side in the depth direction Y, since heat exchange between the inflowing fluid and the outflowing fluid does not occur, it is possible to secure the maximum amount of cold water, and through this, it is possible to improve user satisfaction.

In addition, as illustrated in FIG. 7, in the cold-water generating apparatus according to an exemplary embodiment of the present invention, the block member 200 may include a connection rib 230 for thermally interconnecting one side in the depth direction Y of the unit block 210 such that the cooling member 300 simultaneously cools the plurality of unit blocks 210. For example, the material of the block member 200 is a conductive material, and it may be a metal material such as aluminum or copper, but it may also be a synthetic resin material that is capable of conducting heat as well as such a metal material. As such, when the plurality of unit blocks 210 are thermally interconnected by the connection ribs 230, it is possible to simultaneously cool the plurality of unit blocks 210 by using the cooling member 300, and thus, it is possible to reduce the manufacturing cost and improve manufacturability through structural simplification.

Moreover, as illustrated in FIG. 7, in the apparatus for generating cold water according to an exemplary embodiment of the present invention, the cooling member 300 may include at least one thermoelectric module 310, but the number of thermoelectric modules 310 may be provided to be less than the number of unit blocks 210. For example, a single thermoelectric module 310 is configured to cool two or more unit blocks 210. As such, when the plurality of unit blocks 210 are thermally interconnected by the connection ribs 230, the plurality of unit blocks 210 are simultaneously cooled by using a smaller number of cooling members 300 than the unit blocks 210, and thus, it is possible to reduce the manufacturing cost and improve manufacturability through structural simplification.

As illustrated in FIGS. 5 and 6, in the apparatus for generating cold water according to an exemplary embodiment of the present invention, the cooling passage 110 includes a straight passage 111 through which the fluid flows in a straight direction and a curved passage 112 through which the fluid flows in a curved direction, and the cooling passage 110 may be three-dimensionalized while being wound at least once such that the fluid sequentially flows through the straight passage 111 and the curved passage 112. In this case, it is important that the radius of curvature drawn by the center line of the curved passage 112 is formed to have a minimum radius of curvature in which wrinkles are not formed in the curved passage 112 during a bending process for forming the curved passage 112. This is because, if wrinkles are formed in the curved passage 112, corrosion may occur while fluid is stagnant due to these wrinkles, and deformation problems due to stress concentration may also occur. For example, in the case of the curved passage 112 having an outer diameter of 8 mm, the radius of curvature is preferably about 40 mm. In this way, when the cooling passage 110 is three-dimensionalized while being wound in a state of including the straight passage 111 and the curved passage 112, the length of the entire passage through which the fluid flows through the block-shaped fluid passage is increased such that not only can a sufficient amount of cooled fluid be secured, but also the space efficiency is improved such that the apparatus is miniaturized, and thus, it is possible to improve user satisfaction.

As illustrated in FIG. 4, in the apparatus for generating cold water according to an exemplary embodiment of the present invention, the block member 200 may include a straight block 211 which surrounds the outer circumferential surface of the straight flow path 111, a curved block which surrounds the outer circumferential surface of the curved block 112, and a second separation space 240 for disposing the straight block 211 and the curved block 212 that are disposed to face each other to be spaced apart from each other by a predetermined distance. In this case, the block member 200 is preferably formed to have a sufficient thickness to sufficiently cool the flow path member 100. For example, it is preferable that the thickness of the block member that is respectively disposed on both sides of the flow path member 100 having an outer diameter of 8 mm is 3 mm or more and 7 mm or less. When the thickness is less than 3 mm, the flow path member 100 cannot be sufficiently cooled, and the amount of cooled fluid is reduced. In addition, when the thickness is more than 7 mm, the flow path member 100 can be sufficiently cooled, but there may be other problems in that the weight of the block member 200 is unnecessarily increased. As such, when the straight block 211 and the curved block 212 are provided, the straight passage 111 and the curved passage 112 can be effectively cooled, and the second separation space 240 is formed such that as the straight block 211 and the curved block 212 are disposed to be spaced apart from each other, heat exchange between the cooled fluid and the inflowing fluid can be effectively blocked, and also, as the second separation space 240 is formed, the weight of the block member 200 is reduced, and thus, it is possible to improve user satisfaction through the light weight of an apparatus.

As illustrated in FIG. 5, in the apparatus for generating cold water according to an exemplary embodiment of the present invention, the cooling passages 110 may be stacked in a helical shape. As such, when the cooling passage 110 is stacked and arranged in a helical shape and is three-dimensionalized, the length of the entire passage increases through the block-shaped fluid passage such that it is possible to sufficiently secure the amount of the cooled fluid, and also, the space efficiency is improved such that it is possible to improve user satisfaction because the apparatus is miniaturized.

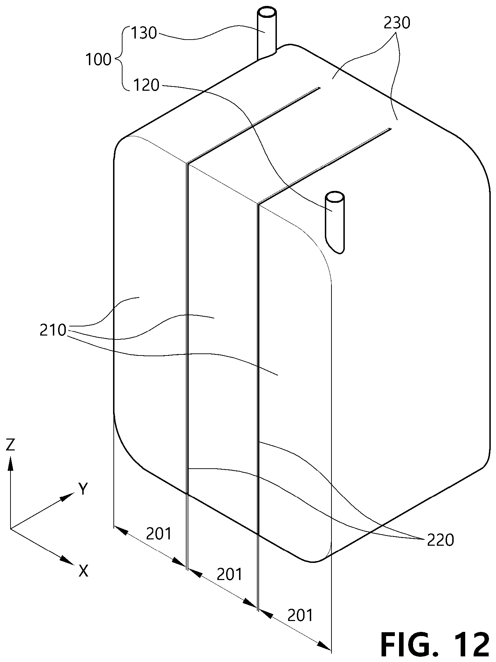

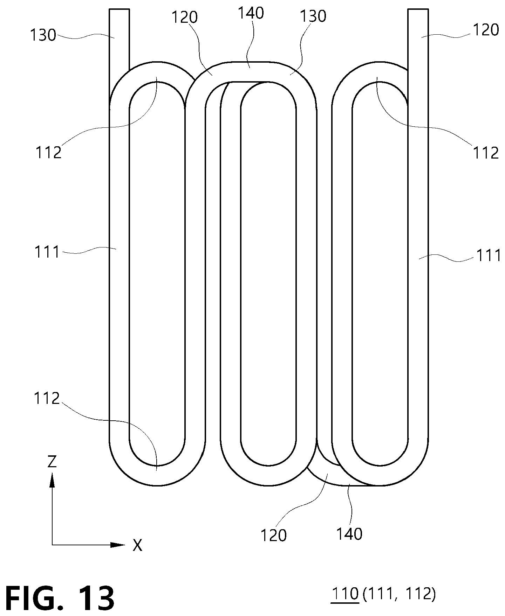

FIG. 12 is a perspective view showing a block member according to another exemplary embodiment of the present invention, and FIG. 13 is a front view showing a flow path member according to another exemplary embodiment of the present invention.

As illustrated in FIG. 12, in the cold-water generating apparatus according to another exemplary embodiment of the present invention, two of the first separation spaces 220 may be formed in the block member 200 such that three zones 201 are formed, and as illustrated in FIG. 13, the cooling passages 110 are respectively disposed in each zone 201. That is, the fluid introduced through the inlet 120 that is disposed on one side in the width direction X is cooled while sequentially passing through the cooling passage 110 and then is discharged to the outside through the outlet 130 that is disposed on the other side in the width direction X. That is, even in this case, the block member 200 is disposed to surround the outer circumferential surface of the flow path member 100 through which the fluid flows, and the temperature at which the fluid is cooled can be sufficiently lowered by cooling the block member 200 such that the fluid is cooled, and also, in addition to being provided in the block member 200, the cooling passages 110 are respectively disposed in a plurality of zones 201 that are thermally separated from each other, and a connection pipe 140 is provided such that the fluid sequentially flows through the cooling passage 110, and through this, it is possible to improve user satisfaction by securing the maximum amount of cold water by preventing heat exchange between the inflowing fluid and the outflowing fluid.

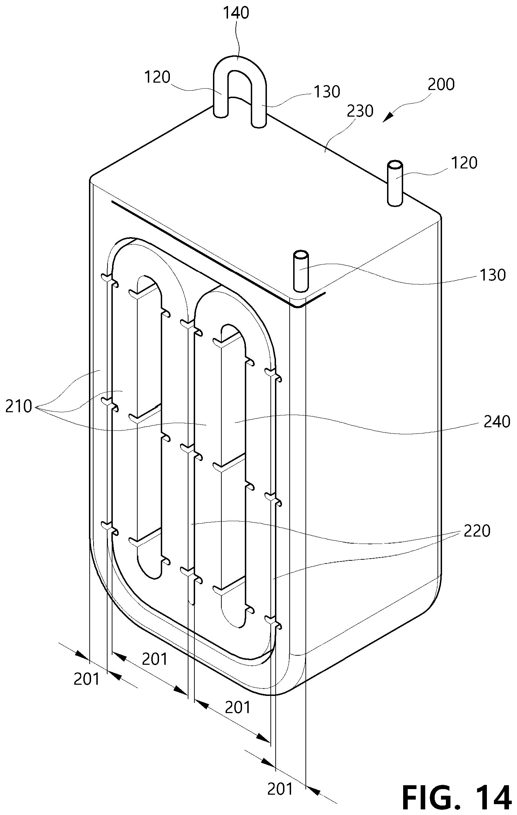

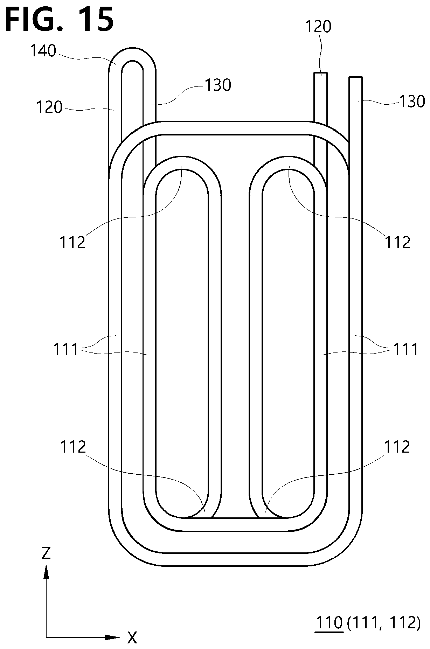

FIG. 14 is a perspective view showing a block member according to another exemplary embodiment of the present invention, and FIG. 15 is a front view showing a flow path member according to another exemplary embodiment of the present invention.

As illustrated in FIG. 14, in the apparatus for generating cold water according to another exemplary embodiment of the present invention, two zones 201 may be formed inside the block member 200, and the first separation space 220 may be formed between the two zones 201 and around the two zones 201 such that one zone 201 surrounding the periphery of these two zones 201 is formed. In addition, as illustrated in FIG. 15, the cooling passages 110 are respectively disposed in each zone 201. That is, the fluid introduced through the inlet 120 of the first cooling passage 110 that is disposed inside is cooled while flowing through the first cooling passage 110, and then moves to the second cooling passage 110 that is disposed inside, and the fluid cooled while flowing through the second cooling passage 110 is cooled while flowing through the third cooling passage 110 surrounding the periphery of the first and second cooling passages 110, and then is discharged to the outside through the outlet 130 of the third cooling passage 110. That is, even in this case, the block member 200 is disposed to surround the outer peripheral surface of the flow path member 100 through which the fluid flows, and the temperature at which the fluid is cooled can be sufficiently lowered by cooling the block member 200 to cool the fluid, and in addition to being provided in the block member 200, the cooling passages 110 are disposed in each of the plurality of zones 201 that are thermally separated from each other, and a connection pipe 140 is provided such that the fluid sequentially flows through the cooling passage 110, and through this, it is possible to improve user satisfaction by securing the maximum amount of cold water by preventing heat exchange between the inflowing fluid and the outflowing fluid.

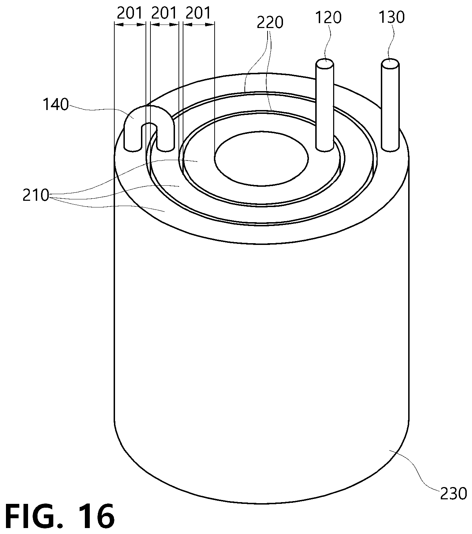

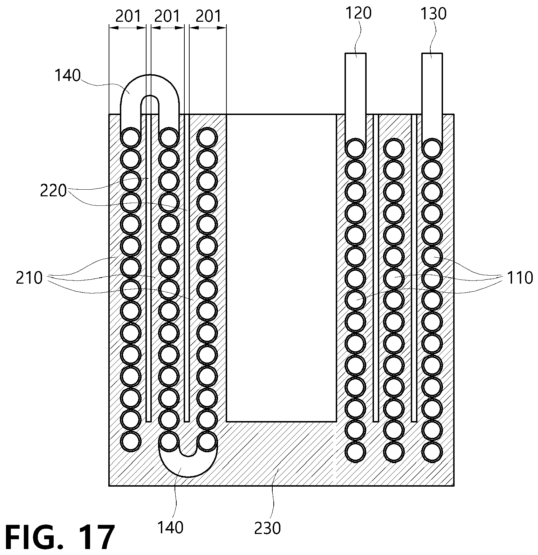

FIG. 16 is a perspective view showing a block member according to another exemplary embodiment of the present invention, and FIG. 17 is a cross-sectional view showing a flow path member according to another exemplary embodiment of the present invention.

As illustrated in FIG. 16, in the apparatus for generating cold water according to another exemplary embodiment of the present invention, two of the first separation spaces 220 may be formed in the block member 200 such that three concentric zones 201 are formed, and as illustrated in FIG. 17, the cooling passages 110 in a helical form are respectively disposed in each zone 201. That is, the fluid introduced through the inlet 120 that is disposed on the innermost side is cooled while sequentially passing through the cooling passage 110 and then discharged to the outside through the outlet 130 that is disposed on the outermost side. That is, even in this case, by disposing the block member 200 so as to surround the outer circumferential surface of the flow path member 100 through which the fluid flows, and cooling the block member 200 such that the fluid is cooled, the temperature at which the fluid is cooled can be sufficiently lowered, and also, in addition to being provided in the block member 200, the cooling passages 110 are respectively disposed in each of the plurality of zones 201 that are thermally separated from each other, and a connection pipe 140 is provided such that fluid sequentially flows through the cooling passages 110, and through this, it is possible to improve user satisfaction by securing the maximum amount of cold water by preventing heat exchange between the inflowing fluid and the outflowing fluid.

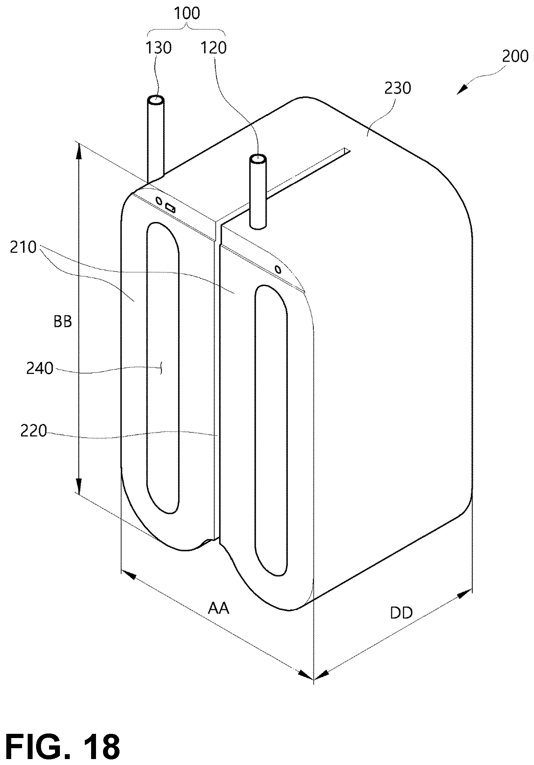

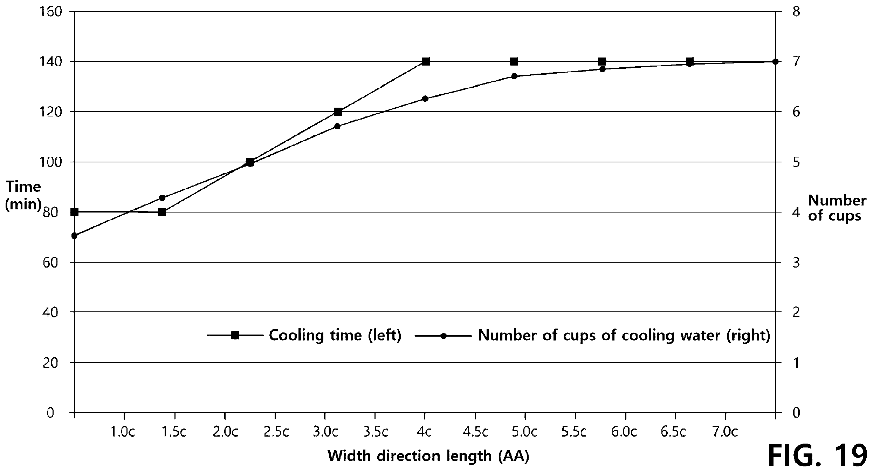

FIG. 18 is a perspective view illustrating the width direction length, depth direction length and height direction length of a block member according to an exemplary embodiment of the present invention, and FIG. 19 is a graph showing changes in cooling time and cooling performance (number of cups) according to the width direction length of the block member according to an exemplary embodiment of the present invention.

As illustrated in FIG. 18, in the apparatus for generating cold water according to an exemplary embodiment of the present invention, the block member 200 may be formed with a width direction length AA that is formed along the width direction X, a height direction length BB that is formed along the height direction Z, and a depth direction length DD that is formed along the depth direction Y.

In this case, in the apparatus for generating cold water according to an exemplary embodiment of the present invention, the thermoelectric module 310 may be provided with a rectangular periphery having a width direction length A and a height direction length B, and when the thermoelectric length C of the thermoelectric module 310 is defined by the mathematical formula of $C=\sqrt{(AB)}$, the width direction length AA of the block member 200 satisfies the range of 1.5C < AA < 4C. That is, basically, it is preferable that the block member 200 has a size sufficient to cool the flow path member 100, but when the block member 200 is formed to be too large, not only it cannot sufficiently cool the block member 200 through the thermoelectric module 310, but also there may be a problem in that the time required to cool the block member 200 is excessively increased, and since there may be a problem in that the weight or volume of the entire apparatus is also increased excessively, the size of the block member 200 is preferably formed to correspond to the size of the thermoelectric module 310. FIG. 19 is a graph showing changes in cooling time and cooling performance (number of cups) according to the width direction length AA of the block member 200, and the x-axis represents the width direction length AA of the block member 200 as a ratio to the size of the thermoelectric module 310, the y-axis shown on the left represents the time it takes for the block member 200 to cool, and the y-axis shown on the right represents the number of cups of cold water and means cooling performance. As illustrated in FIG. 19, it can be confirmed that as the width direction length AA of the block member 200 increases, the time required to cool the block member 200 increases. This means that as the size of the block member 200 increases, the time required to cool it increases. Meanwhile, as the width direction length AA of the block member 200 increases, it can be confirmed that the number of cups of extractable cold water also increases. This is because as the size of the block member 200 increases, the size of the cooling passage 110 that is disposed inside the block member 200 increases, and thus, the amount of fluid accommodated in the cooling passage 110 also increases. Therefore, in consideration of this relationship, the width direction length AA of the block member 200 is preferably formed in the range of 1.5C < AA < 4C. When the width direction length AA of the block member 200 is 1.5C or less, the time required to cool the block member 200 is reduced, but only about 4 cups of the number of cups of cold water can be extracted. However, when the width direction length AA of the block member 200 is more than 1.5C, the time required to cool the block member 200 increases, but the number of cups of extractable cold water rapidly increases, and the tendency for the number of cups of the cold water to rapidly increase is maintained until the width direction length AA of the block member 200 is less than 4C. Meanwhile, when the width direction length AA of the block member 200 is 4C or more, the number of cups of cold water does not increase any more, whereas only the time required for cooling continues to increase. Therefore, as described above, the width direction length AA of the block member 200 is preferably formed in the range of 1.5C < AA < 4C. As described above, if the range of the width direction length AA of the block member 200 is formed to correspond to the size of the thermoelectric module 310, the fluid can be sufficiently cooled, and the entire apparatus can be downsized.

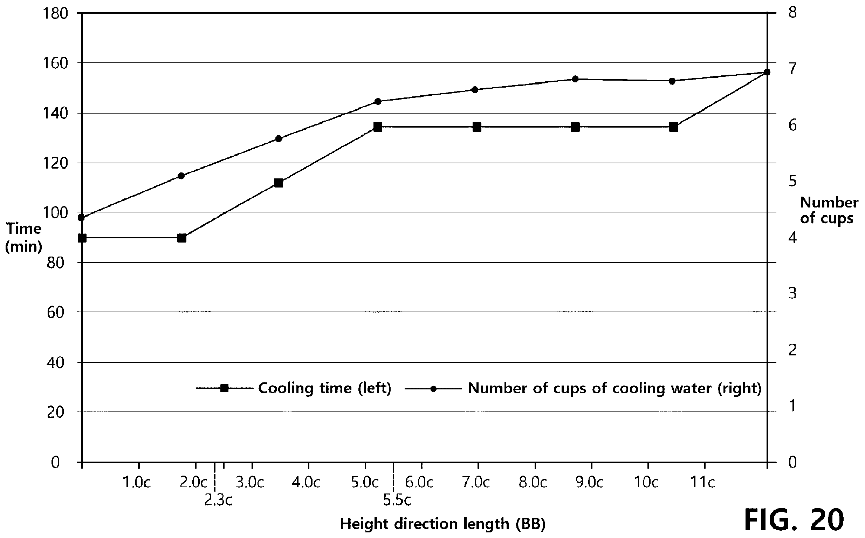

FIG. 20 is a graph showing changes in cooling time and cooling performance (number of cups) according to the height direction length of a block member according to an exemplary embodiment of the present invention.

As illustrated in FIG. 20, in the cold-water generating apparatus according to an exemplary embodiment of the present invention, the thermoelectric module 310 may be provided with a rectangular periphery having a width direction length A and a height direction length B, and when the thermoelectric length C of the thermoelectric module 310 is defined by the mathematical formula of $C=\sqrt{(AB)}$, the height direction length BB of the block member 200 satisfies the range of 2.3C < BB < 5.5C. As described above, it can be confirmed that as the height direction length BB of the block member 200 increases, the time required to cool the block member 200 increases. Meanwhile, as the width direction length AA of the block member 200 increases, it can be confirmed that the number of cups of extractable cold water also increases. Therefore, in consideration of this relationship, the height direction length BB of the block member 200 is preferably formed in the range of 2.3C < BB < 5.5C. When the height direction length BB of the block member 200 is 2.3C or less, the time required to cool the block member 200 is reduced, but only about 4 cups of the number of cups of cold water can be extracted. However, when the height direction length BB of the block member 200 is more than 2.3C, the time required to cool the block member 200 increases, but the number of cups of extractable cold water rapidly increases, and the tendency for the number of cups of the cold water to rapidly increase is maintained until the height direction length BB of the block member 200 is less than 5.5C. Meanwhile, when the height direction length BB of the block member 200 is 5.5C or more, the number of cups of cold water does not increase any more, whereas only the time required for cooling continues to increase. Therefore, as described above, the height direction length BB of the block member 200 is preferably formed in the range of 2.3C < BB < 5.5C. As such, when the range of the height direction length BB of the block member 200 is formed to correspond to the size of the thermoelectric module 310, the fluid can be sufficiently cooled, and the entire apparatus can be downsized.

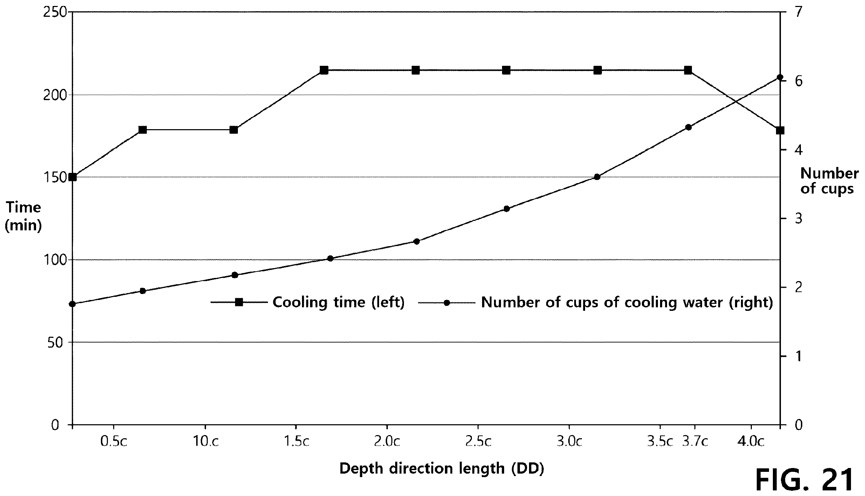

FIG. 21 is a graph illustrating changes in cooling time and cooling performance (number of cups) according to the depth direction length of a block member according to an exemplary embodiment of the present invention.

As illustrated in FIG. 21, in the apparatus for generating cold water according to an exemplary embodiment of the present invention, the thermoelectric module 310 may be provided with a rectangular periphery having a width direction length A and a height direction length B, and when the thermoelectric length C of the thermoelectric module 310 is defined by the mathematical formula of $C=\sqrt{(AB)}$, the depth direction length DD of the block member 200 satisfies the range of C < DD < 3.7C. As described above, as the depth direction length DD of the block member 200 increases, it can be confirmed that the time required to cool the block member 200 increases. Meanwhile, as the depth direction length DD of the block member 200 increases, it can be confirmed that the number of cups of extractable cold water also increases. Therefore, in consideration of this relationship, the depth direction length DD of the block member 200 is preferably formed in the range of C < DD < 3.7C. When the depth direction length DD of the block member 200 is C or less, the time required to cool the block member 200 is reduced, but only about 4 cups of the number of cups of cold water can be extracted. However, when the depth direction length DD of the block member 200 is more than C, the time required to cool the block member 200 increases, but the number of cups of extractable cold water rapidly increases, and the tendency for the number of cups of the cold water to rapidly increase is maintained until the depth direction length DD of the block member 200 is less than 3.7C. Meanwhile, when the depth direction length DD of the block member 200 is 3.7C or more, the number of cups of cold water is rather reduced, and the time required for cooling continues to increase. Therefore, as described above, the depth direction length DD of the block member 200 is preferably formed in the range of C < DD < 3.7C. As such, when the range of the height direction length BB of the block member 200 is formed to correspond to the size of the thermoelectric module 310, the fluid can be sufficiently cooled, and the entire apparatus can be downsized.

As illustrated in FIGS. 8 and 9, the block member 200 may further include a case member 400 that is made of a heat insulating material surrounding the outer circumferential surface. As such, when the case member made of a heat insulating material surrounding the outer circumferential surface of the block member 200 is provided, it is possible to effectively prevent the cooling performance of the block member 200 from being deteriorated. In this case, the case member 400 may include a heat insulating wall 410 that is inserted into the first separation space 220. As an example, the case member 400 may be manufactured by the foam molding method, and if the foam material is configured to be naturally injected into the first separation space 220 during the foam molding process, the insulating wall 410 may be manufactured in a simple manner. The insulating wall 410 may be formed in the upper case 401 and the lower case 402, respectively. By disposing the separate insulating wall 410 between the unit blocks 210 in this way, heat exchange between the unit blocks 210 can be more effectively prevented, and it is possible to improve user satisfaction because the maximum amount of cold water can be secured.

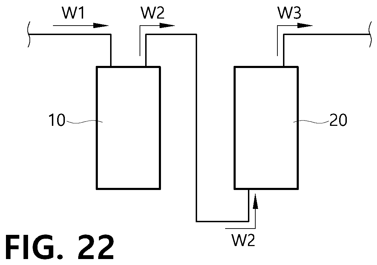

FIG. 22 is a block diagram of a water purifier according to an exemplary embodiment of the present invention.

As illustrated in FIG. 22, the water purifier according to the present invention may include a filtering unit 10 for filtering raw water W1 to generate purified water W2, and a cold water generating unit 20 for generating cold water W3 by receiving purified water W2 from the filtering unit 10. The filtering unit 10 receives raw water W1 from the outside and then filters the raw water W1 to generate purified water W2. The filtering unit 10 may include several filters. For example, the filter unit 10 may include a pre-carbon filter, a membrane filter and an after-carbon filter. In addition, the filtering unit 10 may include an electric deionization-type filter. Electrodeionization methods refer to EDI (Electro Deionization), CEDI (Continuous Electro Deionization), CDI (Capacitive Deionization) and the like. The purified water W2 generated by the filtering unit 10 may be directly supplied to the cold water generating unit 20, or may be supplied to a separate storage unit for storing the purified water W2, and the cold water generating unit 20 may also be configured to receive purified water W2 through such a separate storage unit.

The cold water generating unit 20 may include a flow path member 1-- through which a fluid flows, a block member 200 which surrounds the outer circumferential surface of the flow path member 100 to thermally contact the flow path member 100, and a cooling member 300 which is provided with a thermoelectric module 310 that is disposed on one side of the block member 200 to cool the block member 200. The flow path member 100 provides a space through which the fluid flows. The block member 200 is in thermal contact with the flow path member 100, but is provided to surround the outer circumferential surface of the flow path member 100 to improve cooling performance. As described above, the block member 200 is disposed to surround the outer circumferential surface of the flow path member 100, but in order to minimize contact resistance between the block member 200 and the flow path member 100, the block member 200 may be manufactured by using the die casting method. The cooling member 300 may include a thermoelectric module 310 that is disposed on one side of the block member 200 to cool the block member 200.

The block member 200 may include a plurality of zones 201 that are thermally separated from each other. When the plurality of zones 201 that are thermally separated from each other in this way are formed, heat exchange between the inflowing fluid and the outflowing fluid does not occur, thereby preventing the deterioration of cooling performance. In this case, the flow path member 100 may include first to n-th cooling passages 110 (herein, n is an integer of 2 or more) that are respectively disposed in the plurality of zones 210, an inlet 120 which is formed at one end of each of the cooling passages 100 and exposed to the outside of the block member 200, an outlet 130 which is formed at the other end of each of the cooling passages 110 and exposed to the outside of the block member 200, and a connection pipe 140 which connects the outlet 130 of the k-th cooling passage 110 (herein, k is an integer of 1 or more and less than or equal to n-1) and the inlet 120 of the k+1th cooling passage 100. That is, the cooling passage 110 is disposed in each thermally separated zone 201, and the inlet 120 is exposed to the outside of the block member 200 such that the fluid flows into the cooling passage 110, and as the outlet 130 is exposed to the outside of the block member 200 such that the fluid flows out of the cooling passage 110, it enables the fluid flow inside the cooling passage 110. In this case, a connection pipe 140 is provided to connect the cooling passages 110 that are thermally separated from each other. That is, by disposing the block member 200 so as to surround the outer circumferential surface of the flow path member 100 through which the fluid flows, and cooling the block member 200 such that the fluid is cooled, not only can the temperature at which the fluid is cooled sufficiently lower, but also in addition to being provided in the block member 200, the cooling passages 110 are respectively disposed in each of the plurality of zones 201 that are thermally separated from each other, and a connection pipe 140 is provided such that the fluid sequentially flows through the cooling passages 110, and through this, by preventing heat exchange between the inflowing fluid and the outflowing fluid, it is possible to improve user satisfaction because the maximum amount of cold water is secured.

**Claims**

1. An apparatus for generating cold water (W3), comprising:

    a flow path member (100) through which a fluid flows;
    a block member (200) which surrounds the outer circumferential surface of the flow path member (100) to thermally contact the flow path member (100); and
    a cooling member (300) which is provided with a thermoelectric module (310) that is disposed on one side of the block member (200) to cool the block member (200),
    wherein the block member (200) comprises a plurality of zones (201) that are thermally separated from each other,
    wherein the flow path member (100) comprises first to n-th cooling passages (110) each being disposed in one of the plurality of zones (201), an inlet (120) which is formed at one end of each of the cooling passages (110), an outlet (130) which is formed at the other end of each of the cooling passages (110), and a connection pipe (140) which connects the outlet (130) of the k-th cooling passage and the inlet (120) of the k+1th cooling passage (110),
    wherein at least one of the inlets (120) is exposed to the outside of the block member (200), and at least one of the outlets (130) is exposed to the outside of the block member (230); and
    wherein n is an integer of 2 or more, and k is an integer of 1 or more and less than or equal to n-1, **characterized in that**,
    in the cooling member (300), the thermoelectric module (310) is disposed to overlap the first to n-th cooling passages (110).

2. The apparatus of claim 1, wherein the block member (200) comprises a plurality of unit blocks (210) in which the zones (201) are respectively formed and a first separation space (220) in which each unit block is disposed to be spaced apart from each other by a predetermined distance.

3. The apparatus of claim 2, wherein the thermoelectric module (310) is disposed on one side of the block member (200) in a depth direction (Y),

    wherein the inlet (120) of the k-th cooling passage (110) is disposed, with respect to the depth direction (Y), far from the thermoelectric module (310), and the outlet (130) of the k-th cooling passage (110) is disposed, with respect to the depth direction (Y), close to the thermoelectric module (310), and
    wherein the inlet (120) of the k+1th cooling passage (110) is disposed, with respect to the depth direction (Y), close to the thermoelectric module (310), and the outlet (130) of the k+1th cooling passage (110) is disposed, with respect to the depth direction (Y), far from the thermoelectric module (310).

4. The apparatus of claim 2, wherein the thermoelectric module (310) is disposed on one side of the block member (200) in a depth direction (Y),

    wherein the inlet (120) of the k-th cooling passage (110) is disposed, with respect to the depth direction (Y), far from the thermoelectric module (310), and the outlet (130) of the k-th cooling passage (110) is disposed, with respect to the depth direction (Y), close to the thermoelectric module (310), and
    wherein the inlet (120) of the k+1th cooling passage (110) is disposed, with respect to the depth direction (Y), far from the thermoelectric module (310), and the outlet (130) of the k+1th cooling passage (110) is disposed, with respect to the depth direction (Y), close to the thermoelectric module (310).

5. The apparatus of claim 3, wherein the first separation space (220) is disposed far from the thermoelectric module (310).

6. The apparatus of claim 2, wherein the block member (200) comprises a connection rib (230) that thermally interconnects one side of the unit block in a depth direction such that the cooling member (300) simultaneously cools the plurality of unit blocks (210).

7. The apparatus of claim 6, wherein the cooling member (300) comprises at least one thermoelectric module (310), and wherein the number of thermoelectric modules (310) is less than the number of unit blocks (210).

8. The apparatus of claim 2, wherein the cooling passage (110) comprises a straight passage (111) through which the fluid flows in a straight direction and a curved passage (112) through which the fluid flows in a curved direction, and the cooling passage (110) is wound at least once such that the fluid sequentially flows through the straight passage (111) and the curved passage (112).

9. The apparatus of claim 8, wherein the block member (200) comprises a straight block (211) surrounding the outer circumferential surface of the straight passage (111), a curved block (212) surrounding the outer circumferential surface of the curved passage (112), and a second separation space (240) that spaces apart the straight block (211) and the curved block (212) that are disposed to face each other.

10. The apparatus of claim 2, wherein the cooling passages (110) are stacked in a helical shape.

11. The apparatus of claim 1, wherein the thermoelectric module (310) is provided with a rectangular periphery having a width direction length (A) and a height direction length (B), and

   wherein when the thermoelectric length (C) of the thermoelectric module is defined by the mathematical formula below:

   $$C = \sqrt{(AB)}$$

   the width direction length (AA) of the block member (200) satisfies the following range:

   $$1.5C < AA < 4C.$$

12. The apparatus of claim 1, wherein the thermoelectric module (310) is provided with a rectangular periphery having a width direction length (A) and a height direction length (B), and

   wherein when the thermoelectric length (C) of the thermoelectric module (310) is defined by the mathematical formula below:

   $$C = \sqrt{(AB)}$$

   the height direction length (BB) of the block member (200) satisfies the following range:

   $$2.3C < BB < 5.5C.$$

13. The apparatus of claim 1, wherein the thermoelectric module (310) is provided with a rectangular periphery having a width direction length (A) and a height direction length (B), and

   wherein when the thermoelectric length (C) of the thermoelectric module (310) is defined by the mathematical formula below:

   $$C = \sqrt{(AB)}$$

   the depth direction length (DD) of the block member (200) satisfies the following range:

   $$C < DD < 3.7C.$$

14. The apparatus of claim 2, further comprising: a case member (400) which is made of an insulating material surrounding the outer circumferential surface of the block member (200).

15. The apparatus of claim 14, wherein the case member (400) comprises a heat insulating wall (410) that is inserted and disposed into the first separation space (220).

16. A water purifier, comprising:

   a filtering unit (10) for filtering raw water (W1) to generate purified water (W2); and
   a cold water generating unit (20) for generating cold water (W3) by receiving purified water (W2) from the filtering unit (10),
   wherein the cold water generating unit (20) comprises a flow path member (100) through which a fluid flows, a block member (200) which surrounds the outer circumferential surface of the flow path member (100) to thermally contact the flow path member (100), and a cooling member (300) which is provided with a thermoelectric module (310) that is disposed on one side of the block member (200) to cool the block member (200),
   wherein the block member (200) comprises a plurality of zones (201) that are thermally separated from each other, and
   wherein the flow path member (100) comprises first to n-th cooling passages (110) each being disposed in one of the plurality of zones (201), an inlet (120) which is formed at one end of each of the cooling passages (110), an outlet (130) which is formed at the other end of each of the cooling passages (110), and a connection pipe (140) which connects the outlet (130) of the k-th cooling passage and the inlet (120) of the k+1th cooling passage (110),
   wherein at least one of the inlets (120) is exposed to the outside of the block member (200), and at least one of the outlets (130) is exposed to the outside of the block member (230); and

wherein n is an integer of 2 or more, and k is an integer of 1 or more and less than or equal to n-1, **characterized in that**, in the cooling member (300), the thermoelectric module (310) is disposed to overlap the first to n-th cooling passages (110).

## Patentansprüche

1. Vorrichtung zur Erzeugung von Kaltwasser (W3), umfassend:

   ein Strömungspfadelement (100), durch das ein Fluid strömt;
   ein Blockelement (200), das die Außenumfangsfläche des Strömungspfadelements (100) umgibt, um mit dem Strömungspfadelement (100) thermisch in Kontakt zu treten; und
   ein Kühlelement (300), das mit einem thermoelektrischen Modul (310) versehen ist, das auf einer Seite des Blockelements (200) angeordnet ist, um das Blockelement (200) zu kühlen,
   wobei das Blockelement (200) eine Mehrzahl von Zonen (201) umfasst, die thermisch voneinander getrennt sind,
   wobei das Strömungspfadelement (100) erste bis n-te Kühlkanäle (110), die jeweils in einer der Mehrzahl von Zonen (201) angeordnet sind, einen Einlass (120), der an einem Ende jedes der Kühlkanäle (110) ausgebildet ist, einen Auslass (130), der am anderen Ende jedes der Kühlkanäle (110) ausgebildet ist, und ein Verbindungsrohr (140), das den Auslass (130) des k-ten Kühlkanals und den Einlass (120) des k+1-ten Kühlkanals (110) verbindet, umfasst,
   wobei zumindest einer der Einlässe (120) zur Außenseite des Blockelements (200) hin freiliegt und zumindest einer der Auslässe (130) zur Außenseite des Blockelements (230) hin freiliegt; und
   wobei n eine ganze Zahl von 2 oder größer ist und k eine ganze Zahl von 1 oder größer und kleiner oder gleich n-1 ist, **dadurch gekennzeichnet, dass**
   in dem Kühlelement (300) das thermoelektrische Modul (310) so angeordnet ist, dass es die ersten bis n-ten Kühlkanäle (110) überlappt.

2. Vorrichtung nach Anspruch 1, wobei das Blockelement (200) eine Mehrzahl von Einheitsblöcken (210), in denen jeweils die Zonen (201) ausgebildet sind, und einen ersten Trennraum (220), in dem jeder Einheitsblock so angeordnet ist, dass er von den anderen um einen vorbestimmten Abstand beabstandet ist, umfasst.

3. Vorrichtung nach Anspruch 2, wobei das thermoelektrische Modul (310) auf einer Seite des Blockelements (200) in Tiefenrichtung (Y) angeordnet ist, wobei der Einlass (120) des k-ten Kühlkanals (110) in Bezug auf die Tiefenrichtung (Y) weit entfernt von dem thermoelektrischen Modul (310) angeordnet ist und der Auslass (130) des k-ten Kühlkanals (110) bezüglich der Tiefenrichtung (Y) nahe dem thermoelektrischen Modul (310) angeordnet ist, und wobei der Einlass (120) des k+1-ten Kühlkanals (110) bezüglich der Tiefenrichtung (Y) nahe dem thermoelektrischen Modul (310) angeordnet ist und der Auslass (130) des k+1-ten Kühlkanals (110) bezüglich der Tiefenrichtung (Y) weit entfernt von dem thermoelektrischen Modul (310) angeordnet ist.

4. Vorrichtung nach Anspruch 2, wobei das thermoelektrische Modul (310) auf einer Seite des Blockelements (200) in Tiefenrichtung (Y) angeordnet ist, wobei der Einlass (120) des k-ten Kühlkanals (110) bezüglich der Tiefenrichtung (Y) weit entfernt von dem thermoelektrischen Modul (310) angeordnet ist und der Auslass (130) des k-ten Kühlkanals (110) bezüglich der Tiefenrichtung (Y) nahe dem thermoelektrischen Modul (310) angeordnet ist, und wobei der Einlass (120) des k+1-ten Kühlkanals (110) bezüglich der Tiefenrichtung (Y) weit entfernt von dem thermoelektrischen Modul (310) angeordnet ist und der Auslass (130) des k+1-ten Kühlkanals (110) bezüglich der Tiefenrichtung (Y) nahe dem thermoelektrischen Modul (310) angeordnet ist.

5. Vorrichtung nach Anspruch 3, wobei der erste Trennraum (220) weit entfernt von dem thermoelektrischen Modul (310) angeordnet ist.

6. Vorrichtung nach Anspruch 2, wobei das Blockelement (200) eine Verbindungsrippe (230) umfasst, die eine Seite des Einheitsblocks in Tiefenrichtung thermisch verbindet, so dass das Kühlelement (300) gleichzeitig die Mehrzahl von Einheitsblöcken (210) kühlt.

7. Vorrichtung nach Anspruch 6, wobei das Kühlelement (300) zumindest ein thermoelektrisches Modul (310) umfasst, und wobei die Anzahl der thermoelektrischen Module (310) geringer als die Anzahl der Einheitsblöcke (210) ist.

8. Vorrichtung nach Anspruch 2, wobei der Kühlkanal (110) einen geraden Kanalabschnitt (111), durch den das Fluid in gerader Richtung strömt, und einen gekrümmten Kanalabschnitt (112), durch den das Fluid in gekrümmter Richtung strömt, umfasst, und der Kühlkanal (110) zumindest einmal so gewunden ist, dass das Fluid nacheinander durch den geraden Kanalabschnitt (111) und den gekrümmten Kanalabschnitt (112) strömt.

9. Vorrichtung nach Anspruch 8, wobei das Blockelement (200) einen geraden Block (211), der die Außenumfangsfläche des geraden Kanalabschnitts (111) umgibt, einen gekrümmten Block (212), der die Außenumfangsfläche des gekrümmten Kanalabschnitts (112) umgibt, und einen zweiten Trennraum (240) umfasst, der den geraden Block (211) und den gekrümmten Block (212), die so angeordnet sind, dass sie einander zugewandt sind, voneinander beabstandet.

10. Vorrichtung nach Anspruch 2, wobei die Kühlkanäle (110) in Spiralform gestapelt sind.

11. Vorrichtung nach Anspruch 1, wobei das thermoelektrische Modul (310) mit einem rechteckigen Umfang mit einer Länge (A) in Breitenrichtung und einer Länge (B) in Höhenrichtung versehen ist, und

wobei, wenn die thermoelektrische Länge (C) des thermoelektrischen Moduls durch die nachstehende mathematische Formel definiert ist:

$$C=\sqrt{(AB)}$$

die Länge (AA) des Blockelements (200) in Breitenrichtung den folgenden Bereich erfüllt:

$$1,5C < AA < 4C.$$

12. Vorrichtung nach Anspruch 1, wobei das thermoelektrische Modul (310) mit einem rechteckigen Umfang mit einer Länge (A) in Breitenrichtung und einer Länge (B) in Höhenrichtung versehen ist, und

wobei, wenn die thermoelektrische Länge (C) des thermoelektrischen Moduls (310) durch die nachstehende mathematische Formel definiert ist:

$$C=\sqrt{(AB)}$$

die Länge (BB) des Blockelements (200) in Höhenrichtung den folgenden Bereich erfüllt:

$$2,3C < BB < 5,5C.$$

13. Vorrichtung nach Anspruch 1, wobei das thermoelektrische Modul (310) mit einem rechteckigen Umfang mit einer Länge (A) in Breitenrichtung und einer Länge (B) in Höhenrichtung versehen ist, und

wobei, wenn die thermoelektrische Länge (C) des thermoelektrischen Moduls (310) durch die nachstehende mathematische Formel definiert ist:

$$C=\sqrt{(AB)}$$

die Länge (DD) des Blockelements (200) in Tiefenrichtung den folgenden Bereich erfüllt:

$$C < DD < 3,7C.$$

14. Vorrichtung nach Anspruch 2, ferner umfassend: ein Gehäuseelement (400), das aus einem Isoliermaterial besteht und die Außenumfangsfläche des Blockelements (200) umgibt.

15. Vorrichtung nach Anspruch 14, wobei das Gehäuseelement (400) eine wärmeisolierende Wand (410) umfasst, die in den ersten Trennraum (220) eingesetzt und darin angeordnet ist.

16. Wasserreiniger, umfassend:

eine Filtereinheit (10) zum Filtern von Rohwasser (W1), um gereinigtes Wasser (W2) zu erzeugen; und
eine Kaltwassererzeugungseinheit (20) zur Erzeugung von Kaltwasser (W3) durch Aufnehmen von gereinigtem Wasser (W2) aus der Filtereinheit (10),
wobei die Kaltwassererzeugungseinheit (20) ein Strömungspfadelement (100), durch das ein Fluid strömt, ein Blockelement (200), das die Außenumfangsfläche des Strömungspfadelements (100) umgibt, um das Strömungspfadelement (100) thermisch zu kontaktieren, und ein Kühlelement (300), das mit einem thermoelektrischen Modul (310) versehen ist, das auf einer Seite des Blockelements (200) angeordnet ist, um das Blockelement (200) zu kühlen, umfasst,
wobei das Blockelement (200) eine Mehrzahl von Zonen (201) umfasst, die thermisch voneinander getrennt sind, und
wobei das Strömungspfadelement (100) die ersten bis n-ten Kühlkanäle (110), die jeweils in einer der Mehrzahl von Zonen (201) angeordnet sind, einen Einlass (120), der an einem Ende jedes der Kühlkanäle (110) ausgebildet ist, einen Auslass (130), der am anderen Ende jedes der Kühlkanäle (110) ausgebildet ist, und ein Verbindungsrohr (140), das den Auslass (130) des k-ten Kühlkanals und den Einlass (120) des k+1-ten Kühlkanals (110) verbindet, umfasst,
wobei zumindest einer der Einlässe (120) zur Außenseite des Blockelements (200) hin freiliegt und zumindest einer der Auslässe (130) zur Außenseite des Blockelements (230) hin freiliegt; und

wobei n eine ganze Zahl von 2 oder größer ist und k eine ganze Zahl von 1 oder größer und kleiner oder gleich n-1 ist,

**dadurch gekennzeichnet, dass**

das thermoelektrische Modul (310) in dem Kühlelement (300) so angeordnet ist, dass es die ersten bis n-ten Kühlkanäle (110) überlappt.


**Revendications**

1. Appareil de génération d'eau froide (W3), comprenant :

un élément de voie d'écoulement (100) par lequel s'écoule un fluide ;
un élément de bloc (200) entourant la surface circonférentielle extérieure de l'élément de voie d'écoulement (100) de manière à entrer en contact thermique avec l'élément de voie d'écoulement (100) ; et
un élément de refroidissement (300) pourvu d'un module thermoélectrique (310) disposé sur un côté de l'élément de bloc (200) pour refroidir l'élément de bloc (200),

où l'élément de bloc (200) comprend une pluralité de zones (201) séparées thermiquement les unes des autres,
où l'élément de voie d'écoulement (100) comprend un premier à un n-ième passages de refroidissement (110) disposés chacun dans une zone de la pluralité de zones (201), une entrée (120) formée à une extrémité de chacun des passages de refroidissement (110), une sortie (130) formée à l'autre extrémité de chacun des passages de refroidissement (110), et une conduite de connexion (140) reliant la sortie (130) du k-ième passage de refroidissement à l'entrée (120) du k+1-ième passage de refroidissement (110),
où au moins une des entrées (120) est exposée à l'extérieur de l'élément de bloc (200), et au moins une des sorties (130) est exposée à l'extérieur de l'élément de bloc (230) ; et
où n est un entier égal ou supérieur à 2, et k est un entier égal ou supérieur à 1 et inférieur ou égal à n-1,
**caractérisé en ce que**,
dans l'élément de refroidissement (300), le module thermoélectrique (310) est disposé de manière à chevaucher du premier au n-ième passages de refroidissement (110).

2. Appareil selon la revendication 1, où l'élément de bloc (200) comprend une pluralité de blocs unitaires (210) dans lesquels les zones (201) sont respectivement formées et un premier espace de séparation (220), chaque bloc unitaire étant disposé de manière à être espacé des autres d'une distance prédéterminée.

3. Appareil selon la revendication 2, où le module thermoélectrique (310) est disposé sur un côté de l'élément de bloc (200) dans le sens de la profondeur (Y),

où l'entrée (120) du k-ième passage de refroidissement (110) est disposée à distance du module thermoélectrique (310), dans le sens de la profondeur (Y), et la sortie (130) du k-ième passage de refroidissement (110) est disposée à proximité du module thermoélectrique (310), dans le sens de la profondeur (Y), et
où l'entrée (120) du k+1-ième passage de refroidissement (110) est disposée à proximité du module thermoélectrique (310), dans le sens de la profondeur (Y), et la sortie (130) du k+1-ième passage de refroidissement (110) est disposée à distance du module thermoélectrique (310), dans le sens de la profondeur (Y).

4. Appareil selon la revendication 2, où le module thermoélectrique (310) est disposé sur un côté de l'élément de bloc (200) dans le sens de la profondeur (Y),

où l'entrée (120) du k-ième passage de refroidissement (110) est disposée à distance du module thermoélectrique (310), dans le sens de la profondeur (Y), et la sortie (130) du k-ième passage de refroidissement (110) est disposée à proximité du module thermoélectrique (310), dans le sens de la profondeur (Y), et
où l'entrée (120) du k+1-ième passage de refroidissement (110) est disposée à distance du module thermoélectrique (310), dans le sens de la profondeur (Y), et la sortie (130) du k+1-ième passage de refroidissement (110) est disposée à proximité du module thermoélectrique (310), dans le sens de la profondeur (Y).

5. Appareil selon la revendication 3, où le premier espace de séparation (220) est disposé à distance du module thermoélectrique (310).

6. Appareil selon la revendication 2, où l'élément de bloc (200) comprend une nervure de connexion (230) raccordant thermiquement un côté du bloc unitaire dans le sens de la profondeur, de sorte que l'élément de refroidissement (300) refroidit la pluralité de blocs unitaires (210) simultanément.

7. Appareil selon la revendication 6, où l'élément de refroidissement (300) comprend au moins un module thermoélectrique (310), et où le nombre de modules thermoélectriques (310) est inférieur au nombre de blocs unitaires (210).

8. Appareil selon la revendication 2, où le passage de refroidissement (110) comprend un passage rectiligne (111) où le fluide s'écoule en ligne droite et un passage incurvé (112) où le fluide s'écoule en ligne courbe, et où le passage de refroidissement (110) est enroulé au moins une fois de sorte que le fluide s'écoule séquentiellement dans le passage droit (111) et le passage incurvé (112).

9. Appareil selon la revendication 8, où l'élément de bloc (200) comprend un bloc rectiligne (211) entourant la surface circonférentielle extérieure du passage rectiligne (111), un bloc incurvé (212) entourant la surface circonférentielle extérieure du passage incurvé (112), et un deuxième espace de séparation (240) espaçant le bloc rectiligne (211) du bloc incurvé (212) disposés l'un opposé à l'autre.

10. Appareil selon la revendication 2, où les passages de refroidissement (110) sont empilés en spirale.

11. Appareil selon la revendication 1, où le module thermoélectrique (310) présente une périphérie rectangulaire avec un côté dans le sens de la largeur (A) et un côté dans le sens de la hauteur (B), et

où, si la longueur thermoélectrique (C) du module thermoélectrique est définie par la formule mathématique ci-dessous :

$$C = \sqrt{(AB)}$$

le côté dans le sens de la largeur (AA) de l'élément de bloc (200) satisfait à l'inégalité suivante :

$$1,5C < AA < 4C.$$

12. Appareil selon la revendication 1, où le module thermoélectrique (310) présente une périphérie rectangulaire avec un côté dans le sens de la largeur (A) et un côté dans le sens de la hauteur (B), et

où, si la longueur thermoélectrique (C) du module thermoélectrique (310) est définie par la formule mathématique ci-dessous :

$$C = \sqrt{(AB)}$$

le côté dans le sens de la hauteur (BB) de l'élément de bloc (200) satisfait à l'inégalité suivante :

$$2,3C < BB < 5,5C.$$

13. Appareil selon la revendication 1, où le module thermoélectrique (310) a une périphérie rectangulaire avec un côté dans le sens de la largeur (A) et un côté dans le sens de la hauteur (B), et

où, si la longueur thermoélectrique (C) du module thermoélectrique (310) est définie par la formule mathématique ci-dessous :

$$C = \sqrt{(AB)}$$

le côté dans le sens de la profondeur (DD) de l'élément de bloc (200) satisfait à l'inégalité suivante :

$$C < DD < 3,7C.$$

14. Appareil selon la revendication 2, comprenant en outre :
un élément de boîtier (400) constitué d'un matériau isolant entourant la surface circonférentielle extérieure de l'élément de bloc (200).

15. Appareil selon la revendication 14, où l'élément de boîtier (400) comprend une paroi d'isolation thermique (410) insérée et mise en place dans le premier espace de séparation (220).

16. Purificateur d'eau, comprenant :

une unité de filtration (10) pour filtrer l'eau brute (W1) afin de générer de l'eau purifiée (W2) ; et une unité de génération d'eau froide (20) pour générer de l'eau froide (W3) par réception d'eau purifiée (W2) provenant de l'unité de filtration (10),

où l'unité de génération d'eau froide (20) comprend un élément de voie d'écoulement (100) par lequel s'écoule un fluide, un élément de bloc (200) entourant la surface circonférentielle extérieure de l'élément de voie d'écoulement (100) de manière à entrer en contact thermique avec l'élément de voie d'écoulement (100), et un élément de refroidissement (300) pourvu d'un module thermoélectrique (310) disposé sur un côté de l'élément de bloc (200) pour refroidir l'élément de bloc (200), où l'élément de bloc (200) comprend une pluralité de zones (201) séparées thermiquement les unes des autres, et où l'élément de voie d'écoulement (100) comprend un premier à un n-ième passages de refroidissement (110) disposés chacun dans une zone de la pluralité de zones (201), une entrée (120) formée à une extrémité de chacun des passages de refroidissement (110), une sortie (130) formée à l'autre extrémité de chacun des passages de refroidissement (110), et une conduite de connexion (140) reliant la sortie (130) du k-ième passage de refroidissement à l'entrée (120) du k+1-ième passage de refroidissement (110),

où au moins une des entrées (120) est exposée à l'extérieur de l'élément de bloc (200), et au moins une des sorties (130) est exposée à l'extérieur de l'élément de bloc (230) ; et

où n est un entier égal ou supérieur à 2, et k est un entier égal ou supérieur à 1 et inférieur ou égal à n-1,

**caractérisé en ce que**,

dans l'élément de refroidissement (300), le module thermoélectrique (310) est disposé de manière à chevaucher du premier au n-ième passages de refroidissement (110).

FIG. 1

FIG. 2

FIG. 3

**FIG. 4**

130

120

120

140

100

112

130

111

112

112

111

112

Z

Y

X

112

110 (111, 112)

**FIG. 5**

FIG. 6

FIG. 7

FIG. 8

FIG. 9

FIG. 10

FIG. 11

FIG. 12

**FIG. 13**

110 (111, 112)

FIG. 14

# FIG. 15

FIG. 16

**FIG. 17**

## FIG. 18

FIG. 19

FIG. 20

FIG. 21

FIG. 22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3674630 A, Coway Co., Ltd.
- KR 1020130001910, Coway Co., Ltd.
- KR 101262719, Young-man PARK
- KR 1020140098017, Revotech Co., Ltd
- KR 1020200106673, Coway Co., Ltd
- KR 20140098017 A
- KR 20130140921 A